# EUROPEAN PATENT APPLICATION

(11) **EP 4 669 082 A1**
(43) Date of publication of application: **24.12.2025**
(21) Application number: 25182356.3
(22) Date of filing: 12.06.2025
(51) Int. Cl.: H10K 59/80

(54) **DISPLAY DEVICE, METHOD OF MANUFACTURING DISPLAY DEVICE, AND ELECTRONIC DEVICE INCLUDING DISPLAY DEVICE**

(30) Priority: 21.06.2024 KR 20240080888; 20.08.2024 KR 20240111466
(71) Applicant: Samsung Display Co., Ltd., Yongin-si, Gyeonggi-do 17113 (KR)
(72) Inventor: SONG, Eun Ho, 17113 Yongin-si (KR); SUH, Shin Kook, 17113 Yongin-si (KR); LIM, Seok Hyun, 17113 Yongin-si (KR); JEONG, Da Sol, 17113 Yongin-si (KR)
(74) Representative: Marks & Clerk LLP

(57) **Abstract**

A display device includes: a substrate; circuit elements on the substrate; an insulating layer on the circuit elements and defining via holes, each of the via holes overlapping one of the circuit elements; reflective electrodes on the insulating layer and each overlapping one of first to third light-emitting areas; anode electrodes, each on a corresponding one of the reflective electrodes and each overlapping the corresponding reflective electrode; a light-emitting structure on the anode electrodes; a cathode electrode on the light-emitting structure; and via electrodes in the via holes of the insulating layer between the circuit elements and the reflective electrodes to connect the circuit elements and the reflective electrodes to each other, wherein a distance between one reflective electrode and its corresponding anode electrode that overlaps the reflective electrode is different from a distance between another reflective electrode and its corresponding anode electrode that overlaps the other reflective electrode.

## Description

### BACKGROUND

### 1. Field

Embodiments of the present disclosure relate to a display device. For example, one or more embodiments of the present disclosure relate to a display device, a method of manufacturing the display device, and an electronic device including the display device.

### 2. Description of the Related Art

As information technology advances, the significance of display devices, which serve as interfaces between users and information, is growing. Consequently, the utilization of display devices, such as liquid crystal displays (LCDs) and/or organic light-emitting displays (OLEDs), is on the rise.

Recently, head-mounted display devices (HMDs) have been developed. A head-mounted display device (HMD) is a display device worn by a user in the form of glasses or a helmet, enabling the implementation of virtual reality (VR) or augmented reality (AR) with a focus formed at a close distance in front of the eyes. High-resolution panels are applied to head-mounted display devices, necessitating the use of sub-pixels suitable for these high-resolution panels.

The above information disclosed in this Background section is intended to enhance understanding of the background of the disclosure and may contain information that does not constitute prior art.

### SUMMARY

Aspects of one or more embodiments of the present disclosure are directed to a display device with (having) enhanced or improved brightness overall.

Aspects of one or more embodiments of the present disclosure are directed a method of manufacturing the display device.

Additional aspects will be set forth in part in the description which follows and, in part, will be apparent from the description, or may be learned by practice of the presented embodiments of the disclosure.

A display device according to one or more embodiments of the present disclosure includes: a substrate having first to third light-emitting areas; circuit elements arranged on the substrate; an insulating layer arranged on the circuit elements and defining via holes, each of the via holes overlapping one of the circuit elements; reflective electrodes arranged on the insulating layer and each of the reflective electrodes overlapping one of first to third light-emitting areas; anode electrodes, each of the anode electrodes arranged on a corresponding one of the reflective electrodes and overlapping the corresponding one of the reflective electrodes; a light-emitting structure arranged on the anode electrodes; a cathode electrode arranged on the light-emitting structure; and via electrodes arranged in the via holes of the insulating layer between the circuit elements and the reflective electrodes to connect the circuit elements and the reflective electrodes to each other, wherein a distance between a reflective electrode of the reflective electrodes and its corresponding anode electrode of the anode electrodes that overlaps the reflective electrode in one of the first to third light-emitting areas is different from a distance between another reflective electrode of the reflective electrodes and its corresponding anode electrode of the anode electrodes that overlaps the other reflective electrode in a different one of the first to third light-emitting areas. For example, a display device may include a substrate with three light-emitting areas, circuit elements, an insulating layer with via holes, reflective electrodes, anode electrodes, a light-emitting structure, a cathode electrode, and via electrodes. The distance between each reflective electrode and its corresponding anode electrode may vary across the three light-emitting areas.

In one or more embodiments, the insulating layer may have a planar upper surface except for at the via holes. A distance from each of the reflective electrodes to the substrate may be the same in the first to third light-emitting areas.

In one or more embodiments, at least one of the anode electrodes may have a different distance to the substrate from the rest of the anode electrodes.

In one or more embodiments, the display device may further include an inorganic film arranged between the reflective electrodes and the anode electrodes.

In one or more embodiments, the inorganic film may have a different thickness in at least one of the first to third light-emitting areas relative to in the remaining areas of the first to third light-emitting areas.

In one or more embodiments, the inorganic film may have a smaller thickness in a light-emitting area of the first to third light-emitting areas that emits light of a shorter wavelength than other light-emitting areas of the first to third light-emitting areas.

In one or more embodiments, the inorganic film may overlap the first to third light-emitting areas except for only one light-emitting area from among the first to third light-emitting areas. For example, the inorganic film may overlap the first to third light-emitting areas, except for one light-emitting area among them.

In one or more embodiments, the inorganic film may overlap each of the first to third light-emitting areas and may have the same thickness in only two light-emitting areas from among the first to third light-emitting areas.

In one or more embodiments, the inorganic film may further include contact holes, each of the contact holes overlapping one of the anode electrodes, and each of the anode electrodes may be connected to one of the reflective electrodes by directly contacting the one of the reflective electrodes through one of the contact holes, respectively.

In one or more embodiments, the inorganic film may include at least one of silicon oxide (SiOₓ), silicon nitride (SiNₓ), and/or silicon oxynitride (SiON).

In one or more embodiments, each of the reflective electrodes may include at least one of titanium (Ti), titanium nitride (TiN), tantalum nitride (TaN), aluminum (Al), and/or silver (Ag).

In one or more embodiments, each of the anode electrodes may include at least one of indium tin oxide (ITO), indium zinc oxide (IZO), and/or titanium nitride (TiN).

In one or more embodiments, each of the via electrodes may include at least one of tungsten (W) and/or copper (Cu).

A method of manufacturing a display device according to one or more embodiments of the present disclosure includes: forming circuit elements on a substrate; forming an insulating layer on the circuit elements, the insulating layer defining via holes, each of the via holes overlapping a corresponding one of the circuit elements; forming via electrodes on the circuit elements, each of the via electrodes connected to a corresponding one of the circuit elements through the via holes of the insulating layer; forming reflective electrodes on the insulating layer, each of the reflective electrodes connected to a corresponding one of the via electrodes and each of the reflective electrodes overlapping a corresponding one of first to third light-emitting areas; forming anode electrodes on the reflective electrodes, each of the anode electrodes overlapping a corresponding one of the reflective electrodes; forming a light-emitting structure on the anode electrodes; and forming a cathode electrode on the light-emitting structure, wherein a distance between a reflective electrode of the reflective electrodes and its corresponding anode electrode of the anode electrodes that overlaps the reflective electrode in one of the first to third light-emitting areas is different from a distance between another reflective electrode of the reflective electrodes and its corresponding anode electrode of the anode electrodes that overlaps the other reflective electrode in a different one of the first to third light-emitting areas.

In one or more embodiments, the method may further include, after the forming of the via electrodes, planarizing the insulating layer and the via electrodes through a polishing process.

In one or more embodiments, each of the reflective electrodes may be in contact with the insulating layer, and a distance from each of the reflective electrodes to the substrate may be the same in the first to third light-emitting areas.

In one or more embodiments, the method may further include, after the forming of the reflective electrodes, and before the forming of the anode electrodes, forming an inorganic film on the reflective electrodes.

In one or more embodiments, the inorganic film may include a first inorganic film and a second inorganic film arranged on the first inorganic film.

In one or more embodiments, the forming of the inorganic film may include forming a first preliminary inorganic film on the insulating layer and the reflective electrodes; forming the first inorganic film by removing first portions of the first preliminary inorganic film overlapping two light-emitting areas from among the first to third light-emitting areas; forming a second preliminary inorganic film on the first inorganic film; and forming the second inorganic film by removing a second portion of the second preliminary inorganic film overlapping one light-emitting area from among the first to third light-emitting areas.

In one or more embodiments, the method may further include, before the forming of the anode electrodes, forming contact holes in the inorganic film, each of the contact holes overlapping a corresponding one of the reflective electrodes, wherein each of the anode electrodes may contact a corresponding one of the reflective electrodes through the contact holes in the inorganic film, respectively.

An electronic device according to one or more embodiments of the present disclosure includes: a display device including: a substrate having first to third light-emitting areas; circuit elements arranged on the substrate; an insulating layer arranged on the circuit elements and defining via holes, each of the via holes overlapping one of the circuit elements; reflective electrodes arranged on the insulating layer and each of the reflective electrodes overlapping one of first to third light-emitting areas; anode electrodes, each of the anode electrodes arranged on a corresponding one of the reflective electrodes and overlapping the corresponding one of the reflective electrodes; a light-emitting structure arranged on the anode electrodes; a cathode electrode arranged on the light-emitting structure; and via electrodes arranged in the via holes of the insulating layer between the circuit elements and the reflective electrodes to connect the circuit elements and the reflective electrodes to each other, wherein a distance between a reflective electrode of the reflective electrodes and its corresponding anode electrode of the anode electrodes that overlaps the reflective electrode in one of the first to third light-emitting areas is different from a distance between another reflective electrode of the reflective electrodes and its corresponding anode electrode of the anode electrodes that overlaps the other reflective electrode in a different one of the first to third light-emitting areas.

Specific details of one or more embodiments are included in the detailed description and drawings.

According to the above-described embodiments, because the inorganic film is arranged between the reflective electrodes and the anode electrodes and has a thickness different from corresponding areas in at least one other light-emitting area among the light-emitting areas, the distance between each of the reflective electrodes and the cathode electrode may be different for each light-emitting area. Accordingly, the resonance distance for light emitted from the light-emitting layer of a corresponding light-emitting structure may be adjusted, so that each light-emitting element may have an optimal or improved resonance distance. For example, because the inorganic film is arranged between the reflective electrodes and the anode electrodes and has a different thickness in at least one light-emitting area, the distance between each reflective electrode and the cathode electrode may vary for each light-emitting area. Consequently, the resonance distance for light emitted from the light-emitting layer of each light-emitting structure can be adjusted, allowing each light-emitting element to achieve an optimal or improved resonance distance.

In one or more embodiments, by adjusting the thickness of the inorganic film without planarizing the inorganic film, it may become easy to control the thickness of the inorganic film, i.e., the dispersion for the resonance distance. Accordingly, the partial decrease in brightness in the display device may be provided due to the reduction and or prevention of the dispersion for the resonance distance, and the brightness of the display device may be improved overall. For example, by adjusting the thickness of the inorganic film without planarizing it, controlling the thickness of the inorganic film, and thus the dispersion for the resonance distance, becomes easier. This can reduce or prevent partial decreases in brightness in the display device, thereby improving the overall brightness.

Effects and/or aspects according to one or more embodiments are not limited to those above, and more diverse effects and/or aspects are included in the present specification.

At least some of the above and other features of the invention are set out in the claims.

### BRIEF DESCRIPTION OF THE DRAWINGS

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:
FIG. 1 is a block diagram illustrating a display device according to one or more embodiments of the present disclosure.
FIG. 2 is a block diagram illustrating a sub-pixel of FIG. 1, according to one or more embodiments of the present disclosure.
FIG. 3 is a circuit diagram illustrating the sub-pixel of FIG. 2, according to one or more embodiments of the present disclosure.
FIG. 4 is a plan view illustrating a display panel of FIG. 1, according to one or more embodiments of the present disclosure.
FIG. 5 is an exploded perspective view illustrating a portion of the display panel of FIG. 4, according to one or more embodiments of the present disclosure.
FIG. 6 is a plan view illustrating a pixel of FIG. 5, according to one or more embodiments of the present disclosure.
FIG. 7 is a cross-sectional diagram taken along the line I-I' of FIG. 6, according to one or more embodiments of the present disclosure.
FIG. 8 is a cross-sectional diagram taken along the line I-I' of FIG. 6, according to one or more embodiments of the present disclosure.
FIG. 9 is a cross-sectional diagram taken along the line I-I' of FIG. 6, according to yet one or more embodiments of the present disclosure.
FIG. 10 is a cross-sectional diagram illustrating a portion of a light-emitting structure included in a first to third light-emitting element of FIG. 7, FIG. 8, or FIG. 9, according to one or more embodiments of the present disclosure.
FIG. 11 is a cross-sectional diagram illustrating a portion of a light-emitting structure included in a first to third light-emitting element of FIG. 7, FIG. 8, or FIG. 9, according to one or more embodiments of the present disclosure.
FIG. 12 is a plan view illustrating one or more embodiments of a pixel of FIG. 5, according to one or more embodiments of the present disclosure.
FIG. 13 is a plan view illustrating a pixel of FIG. 5, according to one or more embodiments of the present disclosure.
FIGS. 14 - 25 are cross-sectional diagrams illustrating a method of manufacturing a display device according to one or more embodiments of the present disclosure.
FIG. 26 is a block diagram illustrating a display system according to one or more embodiments of the present disclosure.
FIG. 27 is a perspective view illustrating an application of the display system of FIG. 26, according to one or more embodiments of the present disclosure.
FIG. 28 is a diagram illustrating a head mounted display device of FIG. 27 worn by a user, according to one or more embodiments of the present disclosure.

### DETAILED DESCRIPTION

The present disclosure may be modified in many alternate forms, and thus specific embodiments will be illustrated in the drawings and described in more detail. It should be understood, however, that this is not intended to limit the present disclosure to the particular forms disclosed, but rather, is intended to cover all modifications, equivalents, and alternatives falling within the scope of the present disclosure.

Hereinafter, example embodiments will be described in more detail with reference to the accompanying drawings. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described.

It will be understood that when an element, such as an area, layer, film, region or portion, is referred to as being "on" or "connected to" another element, it can be directly on or connected to the other element, or one or more intervening elements may be present. In contrast, when an element or layer is referred to as being "directly on," "directly connected to", or "immediately adjacent to" another element or layer, there are no intervening elements or layers present. In addition, it will also be understood that when an element is referred to as being "between" two elements, it can be the only element between the two elements, or one or more intervening elements may also be present.

The terminology used herein is for the purpose of describing particular embodiments and is not intended to limit the present disclosure. It will be further understood that the terms "comprises," "comprising," "includes," "including," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Unless otherwise apparent from the disclosure, expressions such as "at least one of," "a plurality of," "one of," and other prepositional phrases, when preceding a list of elements, should be understood as including the disjunctive if written as a conjunctive list and vice versa. For example, the expressions "at least one of a, b, or c," "at least one of a, b, and/or c," "one selected from the group consisting of a, b, and c," "at least one selected from among a, b, and c," "at least one from among a, b, and c," "one from among a, b, and c", "at least one of a to c" indicates only a, only b, only c, both a and b, both a and c, both b and c, all of a, b, and c, or variations thereof.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

Spatially relative terms, such as "on," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the drawings. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Various embodiments are described with reference to drawings that illustrate example embodiments. Accordingly, it will be expected that the shapes may vary, for example, depending on tolerances and/or manufacturing techniques. Accordingly, one or more embodiments disclosed herein should not be construed as being limited to the specific shapes illustrated, but should be construed to include, for example, changes in shapes that occur as a result of manufacturing. As such, the shapes illustrated in the drawings may not depict the actual shapes of areas of the device, and the present disclosure is not limited thereto. In addition, in the drawings, the relative sizes of elements, layers, and regions may be exaggerated for clarity.

Unless otherwise noted, like reference numerals denote like elements throughout the attached drawings and the written description, and thus, duplicative descriptions thereof may not be provided.

As used herein, the singular forms "a," "an" and "the" are intended to include the plural forms as well, unless the context clearly indicates otherwise.

As used herein, the terms "use," "using," and "used" may be considered synonymous with the terms "utilize," "utilizing," and "utilized," respectively.

In the context of the present disclosure and unless otherwise defined, a plan view is an orthographic projection of a three-dimensional object from the position of a horizontal plane through the object. That is, it is a top-down view, showing the layout and spatial relationships of various elements within the object or structure. A plan view based on the direction DR3 refers to a top-down view of the display panel, as if looking directly down onto the surface from above. In this context, DR3 is the direction perpendicular or normal to the plane defined by the first direction DR1 and the second direction DR2. This refers to that in a plan view, the arrangement of sub-pixels, pads, and other components as they are laid out on the substrate can be seen, without any perspective distortion.

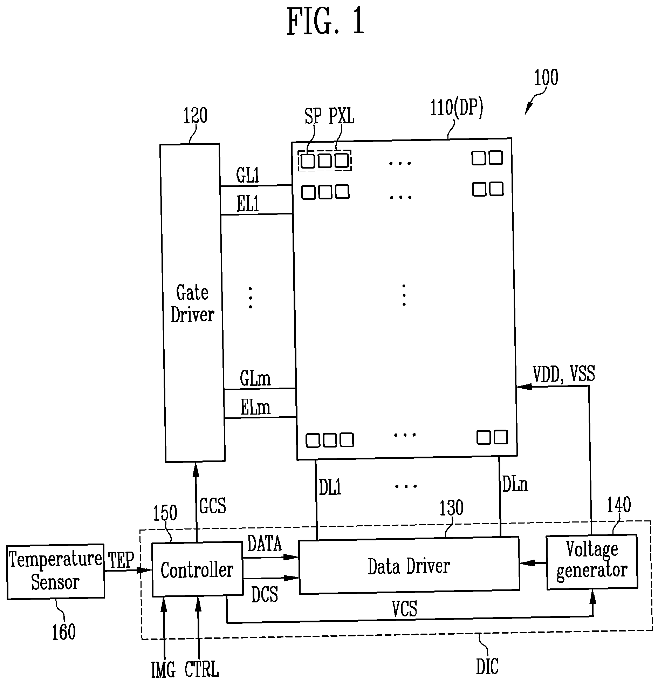

FIG. 1 is a block diagram illustrating a display device according to one or more embodiments of the present disclosure.

Referring to FIG. 1, a display device 100 may include a display panel 110 (also referred to as the display panel DP), a gate driver 120, a data driver 130, a voltage generator 140, and a controller 150.

The display panel 110 includes sub-pixels SP. The sub-pixels SP may be connected to the gate driver 120 through first to m^{th} gate lines GL1-GLm. The sub-pixels SP may be connected to the data driver 130 through first to n^{th} data lines DL1-DLn.

Each of the sub-pixels SP may include at least one light-emitting element configured to generate light. Accordingly, each of the sub-pixels SP may generate light of a specific color, such as red, green, blue, cyan, magenta, yellow, and/or the like. Two or more sub-pixels among the sub-pixels SP may form one pixel PXL. For example, as illustrated in FIG. 1, three sub-pixels may constitute (configure) one pixel PXL.

The gate driver 120 is connected to the sub-pixels SP arranged in the row direction through the first to m^{th} gate lines GL1-GLm. The gate driver 120 may output gate signals to the first to m^{th} gate lines GL1-GLm in response to a gate control signal GCS. In one or more embodiments, the gate control signal GCS may include a start signal indicating the start of each frame, a horizontal synchronization signal for outputting gate signals in synchronization with the timing at which data signals are applied, and/or the like.

In one or more embodiments, first to m^{th} light-emitting control lines EL1-ELm connected to the sub-pixels SP in the row direction may be further provided. In such embodiments, the gate driver 120 may include a light-emitting control driver configured to control the first to m^{th} light-emitting control lines EL1-ELm, and the light-emitting control driver may operate under the control of the controller 150.

The gate driver 120 may be arranged on one side of the display panel 110. However, the present disclosure is not limited thereto. For example, the gate driver 120 may be divided into two or more drivers that are physically and/or logically separated, and such drivers may be arranged on one side of the display panel 110 and the other side of the display panel 110 opposite to the one side. In this way, the gate driver 120 may be arranged on the periphery of the display panel 110 in one or more suitable forms according to one or more embodiments.

The data driver 130 is connected to the sub-pixels SP arranged in the column direction through the first to n^{th} data lines DL1-DLn. The data driver 130 receives image data DATA and a data control signal DCS from the controller 150. The data driver 130 operates in response to the data control signal DCS. In one or more embodiments, the data control signal DCS may include a source start pulse, a source shift clock, a source output enable signal, and/or the like.

The data driver 130 may apply data signals having grayscale voltages corresponding to the image data DATA to the first to n^{th} data lines DL1-DLn using voltages from the voltage generator 140. When a gate signal is applied to each of the first to m^{th} gate lines GL1-GLm, the data signals corresponding to the image data DATA may be applied to the data lines DL1-DLn. Accordingly, the corresponding sub-pixels SP may generate light corresponding to the data signals. Accordingly, an image is displayed on the display panel 110.

In one or more embodiments, the gate driver 120 and the data driver 130 may include complementary metal-oxide semiconductor CMOS circuit elements.

The voltage generator 140 may operate in response to a voltage control signal VCS from the controller 150. The voltage generator 140 is configured to generate a plurality of voltages and provide the generated voltages to components of the display device 100. For example, the voltage generator 140 may be configured to generate a plurality of voltages by receiving an input voltage from outside of the display device 100, adjusting the received voltage, and regulating the adjusted voltage.

The voltage generator 140 may generate a first power supply voltage VDD and a second power supply voltage VSS, and the generated first and second power supply voltages VDD, VSS may be provided to the sub-pixels SP. The first power supply voltage VDD may have a relatively high voltage level, and the second power supply voltage VSS may have a lower voltage level than the first power supply voltage VDD. In one or more embodiments, the first power supply voltage VDD or the second power supply voltage VSS may be provided by an external device of the display device 100.

In one or more embodiments, the voltage generator 140 may generate one or more suitable voltages. For example, the voltage generator 140 may generate an initialization voltage applied to the sub-pixels SP. For example, during a sensing operation for sensing electrical characteristics of transistors and/or light-emitting elements of the sub-pixels SP, a set or predetermined reference voltage may be applied to the first to n^{th} data lines DL1-DLn, and the voltage generator 140 may generate such a reference voltage.

The controller 150 may control all operations of the display device 100. The controller 150 receives input image data IMG from the outside and a control signal CTRL for controlling its display. The controller 150 may provide a gate control signal GCS, a data control signal DCS, and a voltage control signal VCS in response to the control signal CTRL.

The controller 150 may convert the input image data IMG to be suitable for the display device 100 or the display panel 110 and output the image data DATA. In one or more embodiments, the controller 150 may align the input image data IMG to be suitable for the sub-pixels SP of a row unit and output the image data DATA.

Two or more components of the data driver 130, the voltage generator 140, and the controller 150 may be mounted on a single integrated circuit. As illustrated in FIG. 1, the data driver 130, the voltage generator 140, and the controller 150 may be included in a driver integrated circuit DIC. In such embodiments, the data driver 130, the voltage generator 140, and the controller 150 may be functionally separate components within one driver integrated circuit DIC. In one or more embodiments, at least one of the data driver 130, the voltage generator 140, and the controller 150 may be provided as a separate component from the driver integrated circuit DIC.

The display device 100 may include at least one temperature sensor 160. The temperature sensor 160 is configured to sense a temperature of its surroundings and generate temperature data TEP representing the sensed temperature. In one or more embodiments, the temperature sensor 160 may be arranged adjacent to the display panel 110 and/or the driver integrated circuit DIC.

The controller 150 may control one or more suitable operations of the display device 100 in response to the temperature data TEP. In one or more embodiments, the controller 150 may adjust the brightness of an image output from the display panel 110 in response to the temperature data TEP. For example, the controller 150 may adjust data signals and first and second power supply voltages VDD, VSS by controlling components such as the data driver 130 and/or the voltage generator 140.

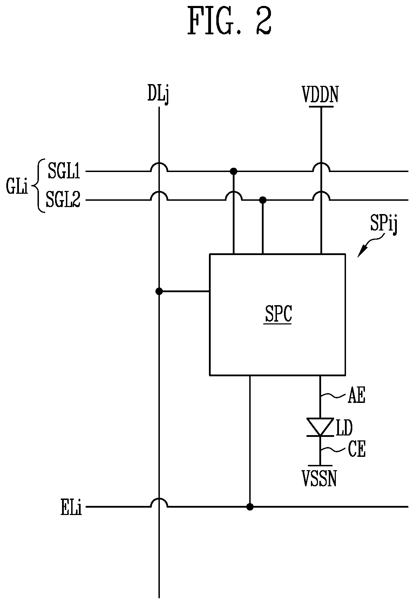

FIG. 2 is a block diagram illustrating a sub-pixel of FIG. 1, according to one or more embodiments of the present disclosure. In FIG. 2, a sub-pixel SPij arranged in an i^{th} row (i is an integer greater than or equal to 1 and less than or equal to m) and a j^{th} column (j is an integer greater than or equal to 1 and less than or equal to n) among the sub-pixels SP of FIG. 1 is illustrated as an example. The remaining sub-pixels SP of the display device 100 may have the same or a similar configuration.

Referring to FIG. 2, the sub-pixel SPij may include a sub-pixel circuit SPC and a light-emitting element LD.

The light-emitting element LD is connected between a first power supply voltage node VDDN and a second power supply voltage node VSSN. In one or more embodiments, the first power supply voltage node VDDN is a node that transfers the first power supply voltage VDD of FIG. 1, and the second power supply voltage node VSSN is a node that transfers the second power supply voltage VSS of FIG. 1.

An anode electrode AE of the light-emitting element LD may be connected to the first power supply voltage node VDDN through the sub-pixel circuit SPC, and a cathode electrode CE of the light-emitting element LD may be connected to the second power supply voltage node VSSN. For example, the anode electrode AE of the light-emitting element LD may be connected to the first power supply voltage node VDDN through one or more transistors included in the sub-pixel circuit SPC.

The sub-pixel circuit SPC may be connected to an i^{th} gate line GLi among the first to m^{th} gate lines GL1-GLm of FIG. 1, an i^{th} light-emitting control line ELi among the first to m^{th} light-emitting control lines EL1-ELm of FIG. 1, and a j^{th} data line DLj among the first to n^{th} data lines DL1-DLn of FIG. 1. The sub-pixel circuit SPC is configured to control the light-emitting element LD according to signals received through these signal lines.

The sub-pixel circuit SPC may operate in response to a gate signal received through the i^{th} gate line GLi. The i^{th} gate line GLi can include one or more sub-gate lines. In one or more embodiments, as illustrated in FIG. 2, the i^{th} gate line GLi may include first and second sub-gate lines SGL1 and SGL2. The sub-pixel circuit SPC may operate in response to the gate signals received through the first and second sub-gate lines SGL1, SGL2. In this way, if (*e.g*., when) the i^{th} gate line GLi includes two or more sub-gate lines, the sub-pixel circuit SPC may operate in response to the gate signals received through the corresponding sub-gate lines.

The sub-pixel circuit SPC may operate in response to a light-emitting control signal received through the i^{th} light-emitting control line ELi. In one or more embodiments, the i^{th} light-emitting control line ELi may include one or more sub-light-emitting control lines. If (e.g., when) the i^{th} light-emitting control line ELi includes two or more sub-light-emitting control lines, the sub-pixel circuit SPC may operate in response to light-emitting control signals received through the corresponding sub-light-emitting control lines.

The sub-pixel circuit SPC may receive a data signal through the j^{th} data line DLj. The sub-pixel circuit SPC may store a voltage corresponding to the data signal in response to at least one of the gate signals received through the first and second sub-gate lines SGL1, SGL2. The sub-pixel circuit SPC may adjust a current flowing from the first power supply voltage node VDDN to the second power supply voltage node VSSN through the light-emitting element LD according to the stored voltage in response to the light-emitting control signal received through the i^{th} light-emitting control line ELi. Accordingly, the light-emitting element LD may generate light having a brightness corresponding to the data signal.

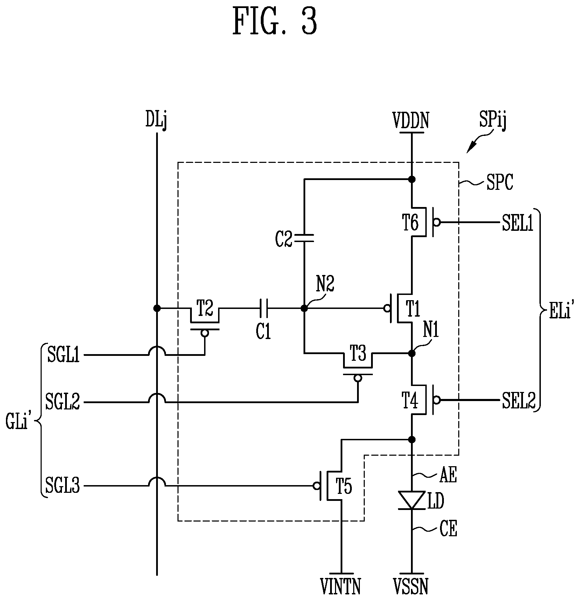

FIG. 3 is a circuit diagram illustrating the sub-pixel of FIG. 2, according to one or more embodiments of the present disclosure.

Referring to FIG. 3, the sub-pixel SPij may include a sub-pixel circuit SPC and a light-emitting element LD.

The sub-pixel circuit SPC may be connected to an i^{th} gate line GLi', an i^{th} light-emitting control line ELi', and a j^{th} data line DLj. Compared with the i^{th} gate line GLi of FIG. 2, the i^{th} gate line GLi' may further include a third sub-gate line SGL3. Compared with the i^{th} light-emitting control line ELi of FIG. 2, the i^{th} light-emitting control line ELi' may include a first sub-light-emitting control line SEL1 and a second sub-light-emitting control line SEL2.

The sub-pixel circuit SPC may include first to sixth transistors T1-T6, and first and second capacitors C1, C2.

The first transistor T1 is connected between the first power supply voltage node VDDN and a first node N1. The gate of the first transistor T1 is connected to a second node N2, and thus, the first transistor T1 may be turned on according to a voltage level of the second node N2. The first transistor T1 may be referred to as a driving transistor.

The second transistor T2 is connected between the j^{th} data line DLj and the second node N2. The gate of the second transistor T2 is connected to the first sub-gate line SGL1, and thus, the second transistor T2 may be turned on in response to a gate signal of the first sub-gate line SGL1. The second transistor T2 may be referred to as a switching transistor.

The third transistor T3 is connected between the first node N1 and the second node N2. The gate of the third transistor T3 is connected to the second sub-gate line SGL2, and thus, the third transistor T3 may be turned on in response to a gate signal of the second sub-gate line SGL2.

The fourth transistor T4 is connected between the first node N1 and the anode electrode AE of the light-emitting element LD. The gate of the fourth transistor T4 is connected to the second sub-light-emitting control line SEL2, and thus, the fourth transistor T4 may be turned on in response to a light-emitting control signal of the second sub-light-emitting control line SEL2.

The fifth transistor T5 is connected between the anode electrode AE of the light-emitting element LD and an initialization voltage node VINTN. The initialization voltage node VINTN is configured to transmit an initialization voltage. In one or more embodiments, the initialization voltage may be provided by the voltage generator 140 of FIG. 1. In one or more embodiments, the initialization voltage may be provided by a device external to the display device 100. The gate of the fifth transistor T5 is connected to the third sub-gate line SGL3, and thus, the fifth transistor T5 may be turned on in response to a gate signal of the third sub-gate line SGL3.

The sixth transistor T6 is connected between the first power supply voltage node VDDN and the first transistor T1. The gate of the sixth transistor T6 is connected to the first sub-light-emitting control line SEL1, and thus, the sixth transistor T6 may be turned on in response to a light-emitting control signal of the first sub-light-emitting control line SEL1.

The first capacitor C1 is connected between the second transistor T2 and the second node N2. The second capacitor C2 is connected between the first power supply voltage node VDDN and the second node N2.

As such, the sub-pixel circuit SPC may include first to sixth transistors T1-T6 and first and second capacitors C1, C2. However, the present disclosure is not limited thereto. The sub-pixel circuit SPC may be implemented as any one of one or more suitable types (kinds) of circuits including a plurality of transistors and one or more capacitors. For example, the sub-pixel circuit SPC may include two transistors and one capacitor. According to one or more embodiments of the sub-pixel circuit SPC, the number of sub-gate lines included in the i^{th} gate line GLi' and the number of sub-light-emitting control lines included in the i^{th} light-emitting control line ELi' may vary.

The first to sixth transistors T1-T6 may be P-type (kind) transistors. Each of the first to sixth transistors T1-T6 may be a metal oxide silicon field effect transistor (MOSFET). However, the present disclosure is not limited thereto. For example, at least one of the first to sixth transistors T1-T6 may be replaced with an N-type (kind) transistor.

In one or more embodiments, the first to sixth transistors T1-T6 may include an amorphous silicon semiconductor, a monocrystalline silicon semiconductor, a polycrystalline silicon semiconductor, an oxide semiconductor, and/or the like.

The light-emitting element LD may include an anode electrode AE, a cathode electrode CE, and a light-emitting layer. The light-emitting layer may be arranged between the anode electrode AE and the cathode electrode CE. After the data signal transmitted through the j^{th} data line DLj is reflected in the voltage of the second node N2, the fourth and sixth transistors T4, T6 may be turned on if (e.g., when) the light-emitting control signals of the first and second sub-light-emitting control lines SEL1, SEL2 are enabled to a low level. In one or more embodiments, the first transistor T1 may be turned on according to the voltage of the second node N2, thereby allowing current to flow from the first power supply voltage node VDDN to the second power supply voltage node VSSN. The light-emitting element LD may be configured to emit light according to the amount of current flowing.

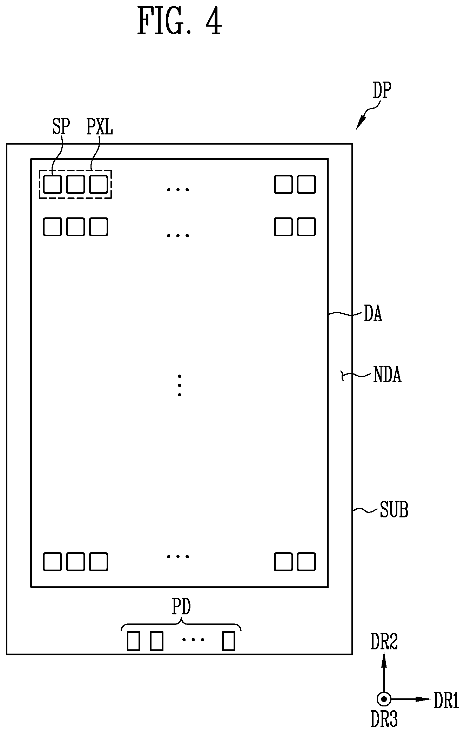

FIG. 4 is a plan view illustrating a display panel of FIG. 1, according to one or more embodiments of the present disclosure.

Referring to FIG. 4, one or more embodiments of the display panel 110 (*i.e.,* the display panel DP) of FIG. 1 may include a display area DA and a non-display area NDA. The display panel DP displays an image through the display area DA. The non-display area NDA is arranged around the display area DA.

The display panel DP may include a substrate SUB, sub-pixels SP, and pads PD.

When the display panel DP is used as a display screen for a head mounted display (HMD), a virtual reality (VR) device, a mixed reality (MR) device, an augmented reality (AR) device, and/or the like, the display panel DP may be located very close to the user's eyes. In such embodiments, sub-pixels SP with a relatively high degree of integration may be used. In order to increase the degree of integration of the sub-pixels SP, the substrate SUB may be provided as a silicon substrate. The sub-pixels SP and/or the display panel DP may be formed on the substrate SUB, which is a silicon substrate. The display device 100 (see, e.g., FIG. 1) including the display panel DP formed on the substrate SUB, which is a silicon substrate, may be referred to as an OLED on Silicon (OLEDoS) display device.

The sub-pixels SP are arranged in the display area DA on the substrate SUB. The sub-pixels SP may be arranged in a matrix form along a first direction DR1 and a second direction DR2 intersecting the first direction DR1. However, the present disclosure is not limited thereto. For example, the sub-pixels SP may be arranged in a zigzag form along the first direction DR1 and the second direction DR2. For example, the sub-pixels SP may be arranged in a PENTILE form (for example, an RGBG matrix, an RGBG structure, or RGBG matrix structure). PENTILE^{®} is a duly registered trademark of Samsung Display Co., Ltd. The first direction DR1 may be a row direction, and the second direction DR2 may be a column direction.

Two or more sub-pixels among the plurality of sub-pixels SP may constitute (may be included in) one pixel PXL.

A component for controlling the sub-pixels SP may be arranged in the non-display area NDA on the substrate SUB. For example, wirings connected to sub-pixels SP, such as the first to m^{th} gate lines GL1-GLm and the first to n^{th} data lines DL1-DLn of FIG. 1, may be arranged in the non-display area NDA.

At least one of the gate driver 120, the data driver 130, the voltage generator 140, the controller 150, and the temperature sensor 160 of FIG. 1 may be integrated in the non-display area NDA of the display panel DP. In one or more embodiments, the gate driver 120 of FIG. 1 may be mounted on the display panel DP but arranged in the non-display area NDA. In one or more embodiments, the gate driver 120 may be implemented as an integrated circuit separate from the display panel DP. In one or more embodiments, the temperature sensor 160 may be arranged in the non-display area NDA to detect the temperature of the display panel DP.

Pads PD are arranged in the non-display area NDA on the substrate SUB. The pads PD may be electrically connected to sub-pixels SP through wirings. For example, the pads PD may be connected to the sub-pixels SP through first to n^{th} data lines DL1-DLn.

The pads PD may interface the display panel DP to other components of the display device 100 (see, e.g., FIG. 1). In one or more embodiments, voltages and signals necessary for the operation of components included in the display panel DP may be provided from the driver integrated circuit DIC of FIG. 1 through the pads PD. For example, the first to n^{th} data lines DL1-DLn may be connected to the driver integrated circuit DIC through the pads PD. For example, first and second power supply voltages VDD, VSS may be received from the driver integrated circuit DIC through the pads PD. For example, if (e.g., when) the gate driver 120 is mounted on the display panel DP, the gate control signal GCS may be transmitted from the driver integrated circuit DIC to the gate driver 120 through the pads PD.

In one or more embodiments, a circuit board may be electrically connected to the pads PD using a conductive adhesive such as an anisotropic conductive film. In one or more embodiments, the circuit board may be a flexible circuit board (FPCB) or a flexible film having a flexible material. The driver integrated circuit DIC may be mounted on the circuit board and electrically connected to the pads PD.

In one or more embodiments, the display area DA may have one or more suitable shapes. The display area DA may have a shape of a closed loop including straight and/or curved sides. For example, the display area DA may have the shape of a polygon, a circle, a semicircle, an ellipse, and/or the like.

In one or more embodiments, the display panel DP may have a planar (substantially planar) display surface. In one or more embodiments, the display panel DP may have at least a partially rounded display surface. In one or more embodiments, the display panel DP may be bendable, foldable, or rollable. In such embodiments, the display panel DP and/or the substrate SUB may include materials having flexible properties.

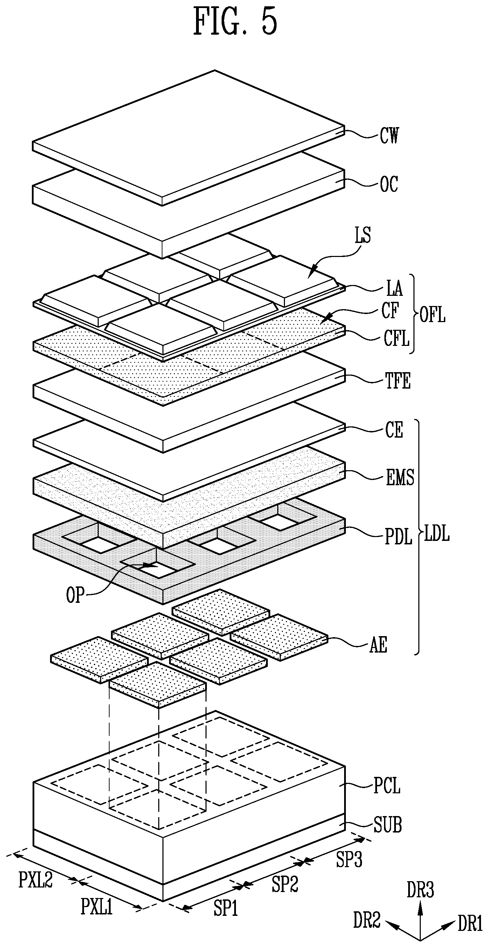

FIG. 5 is an exploded perspective view illustrating a portion of the display panel of FIG. 4, according to one or more embodiments. In FIG. 5, a portion of a display panel DP corresponding to two pixels PXL1, PXL2 among the pixels PXL of FIG. 4 is schematically illustrated for a clear and concise explanation. The portions of the display panel DP corresponding to the remaining pixels may be substantially the same or similarly configured.

Referring to FIGS. 4 and 5, each of the first and second pixels PXL1, PXL2 may include first to third sub-pixels SP1, SP2, SP3. However, the present disclosure is not limited thereto. For example, each of the first and second pixels PXL1, PXL2 may include four sub-pixels or two sub-pixels.

In FIG. 5, the first to third sub-pixels SP1, SP2, SP3 are illustrated as having rectangular shapes and as having the same sizes when viewed in a third direction DR3 intersecting the first and second directions DR1, DR2. However, the present disclosure is not limited thereto. The first to third sub-pixels SP1, SP2, SP3 may be modified to have one or more suitable shapes.

The display panel DP may include a substrate SUB, a pixel circuit layer PCL, a light-emitting element layer LDL, an encapsulation layer TFE, an optical functional layer OFL, an overcoat layer OC, and a cover window CW.

In one or more embodiments, the substrate SUB may include a silicon wafer substrate formed using a semiconductor process. The substrate SUB may include a semiconductor material suitable for forming circuit elements. For example, the semiconductor material may include silicon, germanium, and/or silicon-germanium. The substrate SUB may be provided from a bulk wafer, an epitaxial layer, a silicon on insulator (SOI) layer, or a semiconductor on insulator (SeOI) layer. In one or more embodiments, the substrate SUB may include a glass substrate. In one or more embodiments, the substrate SUB may include a polyimide PI substrate.

The pixel circuit layer PCL is arranged on the substrate SUB. The substrate SUB and/or the pixel circuit layer PCL may include insulating layers and conductive patterns arranged between the insulating layers. The conductive patterns of the pixel circuit layer PCL may function as at least a portion of circuit elements, wirings, and/or the like. The conductive patterns may include copper, but the present disclosure is not limited thereto.

The circuit elements may include a sub-pixel circuit SPC, see, e.g., FIG. 2 of each of the first to third sub-pixels SP1, SP2, SP3. The sub-pixel circuit SPC may include transistors and one or more capacitors. Each transistor may include a semiconductor portion including a source area, a drain area, and a channel area, and a gate electrode overlapping the semiconductor portion. In one or more embodiments, if (e.g., when) the substrate SUB is provided as a silicon substrate, the semiconductor portion may be included in the substrate SUB, and the gate electrode may be included in the pixel circuit layer PCL as a conductive pattern of the pixel circuit layer PCL. In one or more embodiments, if (e.g., when) the substrate SUB is provided as a glass substrate or a PI substrate, the semiconductor portion and the gate electrode may be included in the pixel circuit layer PCL. Each capacitor may include electrodes spaced and/or apart (e.g., spaced apart or separated) from each other. For example, each capacitor may include electrodes spaced and/or apart (e.g., spaced apart or separated) from each other in a plane defined by the first and second directions DR1, DR2 (e.g., a plan view). For example, each capacitor may include electrodes spaced and/or apart (e.g., spaced apart or separated) from each other in the third direction DR3 with an insulating layer interposed therebetween.

The wirings of the pixel circuit layer PCL may include signal lines, such as a gate line, a light-emitting control line, and a data line, connected to each of the first to third sub-pixels SP1, SP2, SP3. The wirings may further include wiring connected to the first power supply voltage node VDDN of FIG. 2. In one or more embodiments, the wirings may further include wiring connected to the second power supply voltage node VSSN of FIG. 2.

The light-emitting element layer LDL may include anode electrodes AE, a pixel definition layer PDL, a light-emitting structure EMS, and a cathode electrode CE.

The anode electrodes AE may be arranged on the pixel circuit layer PCL. The anode electrodes AE may contact circuit elements of the pixel circuit layer PCL. The anode electrodes AE may include an opaque conductive material capable of reflecting light, but the present disclosure is not limited thereto.

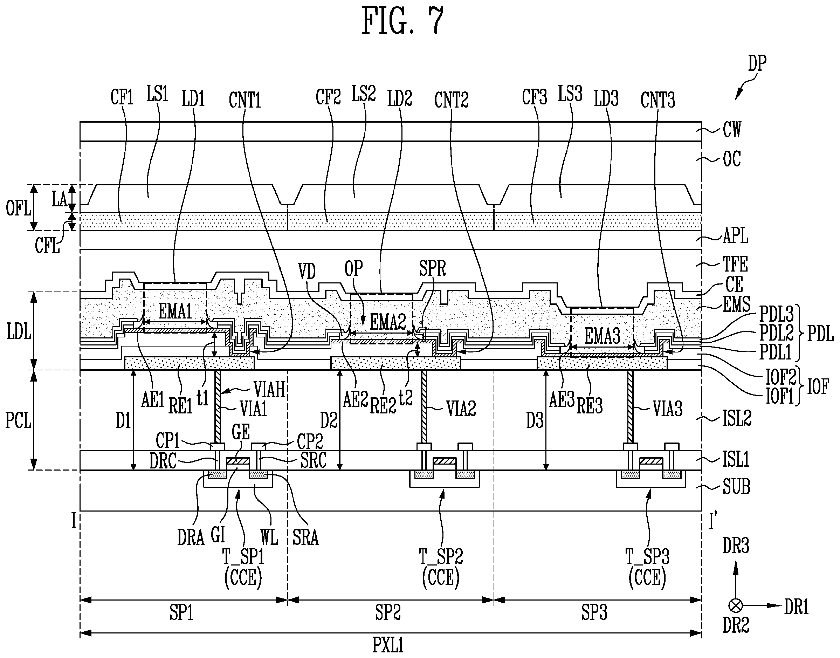

The pixel definition layer PDL is arranged on the anode electrodes AE. The pixel definition layer PDL may include an opening OP exposing a portion of each of the anode electrodes AE. Light-emitting areas EMA1-EMA3, see, e.g., FIG. 7 corresponding to the first to third sub-pixels SP1-SP3, respectively, may be defined according to the openings OP of the pixel definition layer PDL. Alternatively, in one or more embodiments, it may be understood that the light-emitting areas corresponding to the first to third sub-pixels SP1-SP3 are defined respectively according to the anode electrodes AE. In an area adjacent to a boundary between neighboring sub-pixels, the pixel definition layer PDL may include a separator that causes a discontinuity to be formed in the light-emitting structure EMS. In such embodiments, it may be understood that the light-emitting areas corresponding to the first to third sub-pixels SP1-SP3 are defined respectively according to the separators of the pixel definition layer PDL.

In one or more embodiments, the pixel definition layer PDL may include an inorganic material. In such embodiments, the pixel definition layer PDL may include a plurality of laminated inorganic layers. For example, the pixel definition layer PDL may include silicon oxide (SiOₓ, where 0 < x ≤ 2, *e.g*., SiO₂) and silicon nitride (SiₓN_{y}, where 0 < x ≤ 3 and 0 < y ≤ 4, *e.g*., Si₃N₄). In one or more embodiments, the pixel definition layer PDL may include an organic material. However, the material of the pixel definition layer PDL is not limited thereto.

The light-emitting structure EMS may be arranged on the anode electrodes AE exposed by the openings OP of the pixel definition layer PDL. The light-emitting structure EMS may include a light-emitting layer configured to generate light, an electron transport layer configured to transport electrons, and a hole transport layer configured to transport holes.

In one or more embodiments, the light-emitting structure EMS may be arranged over all of the upper part of the pixel defining layer PFL (e.g., on the entire (substantially the entire) upper part of the pixel definition layer PDL) while filling the openings OP of the pixel definition layer PDL. For example, the light-emitting structure EMS may extend across the first to third sub-pixels SP1-SP3. In such embodiments, at least a portion of the layers in the light-emitting structure EMS may be disconnected or bent at the boundaries between the first to third sub-pixels SP1-SP3. However, the present disclosure is not limited thereto. For example, portions of the light-emitting structure EMS corresponding to the first to third sub-pixels SP1-SP3 may be separated from each other, and each of them may be arranged within the openings OP of the pixel definition layer PDL.

The cathode electrode CE may be arranged on the light-emitting structure EMS. The cathode electrode CE may extend across the first to third sub-pixels SP1-SP3. As such, the cathode electrode CE may be provided as a common electrode for the first to third sub-pixels SP1-SP3.

The cathode electrode CE may be a thin metal layer having a thickness sufficient to transmit light emitted from the light-emitting structure EMS. The cathode electrode CE may be formed of a metal material to have a relatively thin thickness or may be formed of a transparent conductive material. In one or more embodiments, the cathode electrode CE may include at least one of one or more suitable transparent conductive materials, including indium tin oxide, indium zinc oxide, indium tin zinc oxide, aluminum zinc oxide, gallium zinc oxide, zinc tin oxide, or gallium tin oxide. In one or more embodiments, the cathode electrode CE may include at least one of silver (Ag), magnesium (Mg), and/or mixtures thereof. However, the material of the cathode electrode CE is not limited thereto.

Each one of the anode electrodes AE, a portion of the light-emitting structure EMS overlapping it, and a portion of the cathode electrode CE overlapping it may be understood to constitute one light-emitting element (LD, see, e.g., FIG. 2). For example, each of the light-emitting elements of the first to third sub-pixels SP1-SP3 may include one anode electrode, a portion of the light-emitting structure EMS overlapping it, and a portion of the cathode electrode CE overlapping it. In each of the first to third sub-pixels SP1-SP3, holes injected from the anode electrode AE and electrons injected from the cathode electrode CE are transported into the light-emitting layer of the light-emitting structure EMS to form excitons, and if (e.g., when) the excitons transition from an excited state to a ground state, light may be generated. The brightness of the light may be determined according to the amount of current flowing through the light-emitting layer. The wavelength range of the generated light may be determined according to the configuration of the light-emitting layer.

The encapsulation layer TFE is arranged on the cathode electrode CE. The encapsulation layer TFE may cover the light-emitting element layer LDL and/or the pixel circuit layer PCL. The encapsulation layer TFE may be configured to prevent or protect from oxygen and/or moisture, and/or the like, penetrating into the light-emitting element layer LDL. In one or more embodiments, the encapsulation layer TFE may include a structure in which one or more inorganic films and one or more organic films are alternately laminated. For example, the inorganic films may include silicon nitride, silicon oxide, or silicon oxynitride (SiOₓN_{y}, *e.g.*, Si₂N₂O). For example, the organic films may include an organic insulating material, such as an acrylic resin, an epoxy resin, a phenol resin, a polyamide resin, a polyimide resin, an unsaturated polyester resin, a polyphenyleneether resin, a polyphenylenesulfide resin, or benzocyclobutene (BCB). However, the materials of the organic films and the inorganic films of the encapsulation layer TFE are not limited thereto.

In order to improve the encapsulation efficiency of the encapsulation layer TFE, the encapsulation layer TFE may further include a thin film including aluminum oxide (AlₓO_{y}, where 0 < x ≤ 2 and 0 < y ≤ 3, *e.g.,* Al₂O₃). The thin film including aluminum oxide may be located on an upper surface of the encapsulation layer TFE facing (*e.g.,* opposite to) the optical functional layer OFL and/or a lower surface of the encapsulation layer TFE facing (*e.g*., opposite to) the light-emitting element layer LDL.

The thin film including aluminum oxide may be formed by an atomic layer deposition (ALD) method. However, the present disclosure is not limited thereto. The encapsulation layer TFE may further include a thin film formed of at least one of various materials suitable for improving the encapsulation efficiency.

The optical functional layer OFL is arranged on the encapsulation layer TFE. The optical functional layer OFL may include a color filter layer CFL and a lens array LA.

The color filter layer CFL is arranged between the encapsulation layer TFE and the lens array LA. The color filter layer CFL is configured to filter light emitted from the light-emitting structure EMS to selectively output light of a wavelength range or color corresponding to each sub-pixel SP. The color filter layer CFL includes color filters CF corresponding to the first to third sub-pixels SP1-SP3, respectively, and each of the color filters CF may be configured to transmit light of a wavelength range corresponding to the corresponding sub-pixel SP. For example, the color filter corresponding to the first sub-pixel SP1 may be to transmit red color light, the color filter corresponding to the second sub-pixel SP2 may be to transmit green color light, and the color filter corresponding to the third sub-pixel SP3 may be to transmit blue color light. At least some of the color filters CF may not be provided depending on the light emitted from the light-emitting structure EMS of each sub-pixel SP.

The lens array LA is arranged on the color filter layer CFL. The lens array LA may include lenses LS corresponding to the first to third sub-pixels SP1-SP3, respectively. Each of the lenses LS may improve light emission efficiency by outputting light emitted from the light-emitting structure EMS to an intended path. The lens array LA may have a relatively high refractive index. For example, the lens array LA may have a higher refractive index than the overcoat layer OC. In one or more embodiments, the lenses LS may include an organic material. In one or more embodiments, the lenses LS may include an acrylic material. However, the material of the lenses LS is not limited thereto.

In one or more embodiments, at least some of the color filters CF of the color filter layer CFL and at least some of the lenses LS of the lens array LA may be shifted in a direction parallel to a plane defined by the first and second directions DR1, DR2 relative to the openings OP of the pixel definition layer PDL. For example, in a central area of the display area DA, a center of the color filters CF and a center of the lenses LS may be aligned with or overlap a center of the corresponding openings OP of the pixel definition layer PDL when viewed in the third direction DR3. For example, in the central area of the display area DA, the openings OP of the pixel definition layer PDL may completely overlap a corresponding color filters CF of the color filter layer CFL and a corresponding lenses LS of the lens array LA. In the area adjacent to the non-display area NDA in the display area DA, the center of the color filters CF and the center of the lenses LS may be shifted in the plane direction (defined by the first and second directions DR1 and DR2) from the center of the corresponding openings OP of the pixel definition layer PDL when viewed in the third direction DR3. For example, in the central area of the display area DA, the centers of the color filters CF and lenses LS may align with or overlap the centers of the corresponding openings OP of the pixel definition layer PDL when viewed in the third direction DR3. In this central area, the openings OP of the pixel definition layer PDL may completely overlap the corresponding color filters CF and lenses LS. In the area adjacent to the non-display area NDA in the display area DA, the centers of the color filters CF and lenses (LS) may be shifted in the plane direction (defined by the first and second directions DR1 and DR2) from the centers of the corresponding openings OP of the pixel definition layer PDL when viewed in the third direction DR3 (in a plan view). For example, in the area adjacent to the non-display area NDA in the display area DA, the openings OP of the pixel definition layer PDL may partially overlap the corresponding color filters CF of the color filter layer CFL and the corresponding lenses LS of the lens array LA. Accordingly, in the center of the display area DA, light emitted from the light-emitting structure EMS may be efficiently output in a direction normal (e.g., perpendicular) to the display surface. In an outer region of the display area DA, light emitted from the light-emitting structure EMS may be efficiently output in a direction inclined at a set or predetermined angle with respect to the normal direction of the display surface. The overcoat layer OC may be arranged on the lens array LA. The overcoat layer OC may cover the optical functional layer OFL, the encapsulation layer TFE, the light-emitting structure EMS, and/or the pixel circuit layer PCL. The overcoat layer OC may include one or more suitable materials suitable for protecting its lower layers from foreign substances such as dust, moisture, and/or the like. For example, the overcoat layer OC may include at least one of an inorganic insulating film and an organic insulating film. For example, the overcoat layer OC may include epoxy, but the present disclosure is not limited thereto. The overcoat layer OC may have a lower refractive index than the lens array LA.

The cover window CW may be arranged on the overcoat layer OC. The cover window CW is configured to protect its lower layers. The cover window CW may have a higher refractive index than the overcoat layer OC. The cover window CW may include glass, but the present disclosure is not limited thereto. For example, the cover window CW may be an encapsulation glass configured to protect components arranged thereunder. In one or more embodiments, the cover window CW may not be provided.

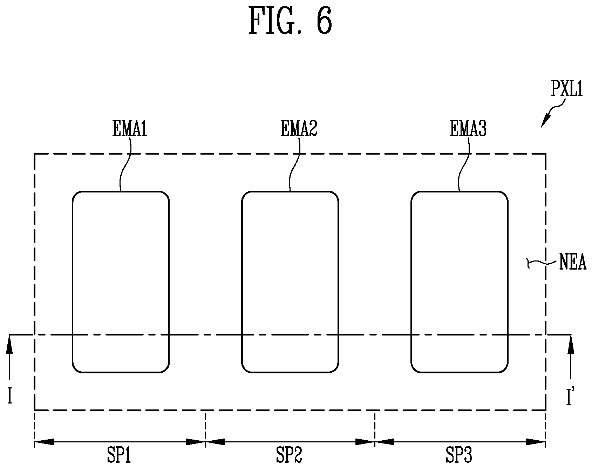

FIG. 6 is a plan view illustrating a pixel of FIG. 5, according to one or more embodiments of the present disclosure. In FIG. 6, a first pixel PXL1 among the first and second pixels PXL1, PXL2 of FIG. 5 is schematically illustrated for a clear and concise explanation. The remaining pixels may be configured substantially the same or similarly to the first pixel PXL1.

Referring to FIGS. 5 and 6, the first pixel PXL1 may include first to third sub-pixels SP1-SP3 arranged in the first direction DR1.

The first sub-pixel SP1 may include a first light-emitting area EMA1 and a non-emitting area NEA around the first light-emitting area EMA1. The second sub-pixel SP2 may include a second light-emitting area EMA2 and the non-emitting area NEA around the second light-emitting area EMA2. The third sub-pixel SP3 may include a third light-emitting area EMA3 and the non-emitting area NEA around the third light-emitting area EMA3.

The first light-emitting area EMA1 may be an area where light is to be emitted from a portion of the light-emitting structure (EMS, see, e.g., FIG. 5) corresponding to the first sub-pixel SP1. The second light-emitting area EMA2 may be an area where light is to be emitted from a portion of the light-emitting structure EMS corresponding to the second sub-pixel SP2. The third light-emitting area EMA3 may be an area where light is to be emitted from a portion of the light-emitting structure EMS corresponding to the third sub-pixel SP3.

FIG. 7 is a cross-sectional diagram taken along the line I-I' of FIG. 6, according to one or more embodiments of the present disclosure.

Referring to FIG. 7, a substrate SUB and a pixel circuit layer PCL arranged on the substrate SUB are provided.

The substrate SUB may include a silicon wafer substrate formed using a semiconductor process. For example, the substrate SUB may include silicon, germanium, and/or silicon-germanium.

The pixel circuit layer PCL is arranged on the substrate SUB. The substrate SUB and the pixel circuit layer PCL may include circuit elements CCE of each of the first to third sub-pixels SP1-SP3. For example, the substrate SUB and the pixel circuit layer PCL may include a transistor T_SP1 of the first sub-pixel SP1, a transistor T_SP2 of the second sub-pixel SP2, and a transistor T_SP3 of the third sub-pixel SP3. The transistor T_SP1 of the first sub-pixel SP1 may be any one of the transistors included in the sub-pixel circuit SPC, see, e.g., FIG. 2 of the first sub-pixel SP1, the transistor T_SP2 of the second sub-pixel SP2 may be any one of the transistors included in the sub-pixel circuit SPC of the second sub-pixel SP2, and the transistor T_SP3 of the third sub-pixel SP3 may be any one of the transistors included in the sub-pixel circuit SPC of the third sub-pixel SP3. In FIG. 7, for clear and concise explanation, one of the transistors of each sub-pixel is illustrated, and the remaining circuit elements CCE are not provided.

The transistor T_SP1 of the first sub-pixel SP1 may include a source area SRA, a drain area DRA, and a gate electrode GE.

The source area SRA and the drain area DRA may be arranged within the substrate SUB. A well WL formed through an ion implantation process is arranged in the substrate SUB, and the source area SRA and the drain area DRA may be arranged to be spaced and/or apart (e.g., spaced apart or separated) from each other in the well WL. An area between the source area SRA and the drain area DRA in the well WL may be defined as a channel area. The gate electrode GE overlaps the channel area between the source area SRA and the drain area DRA and may be arranged in the pixel circuit layer PCL. The gate electrode GE may be spaced from the well WL or the channel area by an insulating material such as a gate insulating layer GI. The gate electrode GE may include a conductive material.

A plurality of layers included in the pixel circuit layer PCL include insulating layers (for example, a first insulating layer ISL1 and a second insulating layer ISL2) and conductive patterns arranged between the insulating layers, and such conductive patterns may include first and second conductive patterns CP1, CP2. The first conductive pattern CP1 may be electrically connected to the drain area DRA through a drain connector DRC penetrating the first insulating layer ISL1 composed of one or more insulating layers. The second conductive pattern CP2 may be electrically connected to the source area SRA through a source connector SRC penetrating the first insulating layer ISL1 composed of one or more insulating layers.

As the gate electrode GE and the first and second conductive patterns CP1, CP2 are connected to other circuit elements and/or wirings, the transistor T_SP1 of the first sub-pixel SP1 may be provided as any one of the transistors of the first sub-pixel SP1.

Each of the transistor T_SP2 of the second sub-pixel SP2 and the transistor T_SP3 of the third sub-pixel SP3 may be configured substantially the same or similarly to the transistor T_SP1 of the first sub-pixel SP1.

As such, the substrate SUB and the pixel circuit layer PCL may include circuit elements CCE of each of the first to third sub-pixels SP1-SP3.

The second insulating layer ISL2 is arranged on the circuit elements CCE and the first insulating layer ISL1. The second insulating layer ISL2 may cover the circuit elements CCE. The second insulating layer ISL2 may have an overall planar upper surface (e.g., a planar surface over an entirety or substantially the entirety of the second insulating layer ISL2). For example, the second insulating layer ISL2 is configured to planarize steps on the circuit elements CCE. The second insulating layer ISL2 may include at least one of silicon oxide SiOx, silicon nitride SiNx, and/or silicon carbon nitride SiCN, but the present disclosure is not limited thereto.

The second insulating layer ISL2 may define via holes VIAH penetrating the second insulating layer ISL2. The via holes VIAH may overlap the circuit elements CCE, respectively. For example, the second insulating layer ISL2 may have a planar upper surface except for the portion where the via holes VIAH are defined.

The light-emitting element layer LDL is arranged on the second insulating layer ISL2. The light-emitting element layer LDL may include first to third reflective electrodes RE1-RE3, an inorganic film IOF, first to third anode electrodes AE1-AE3, a pixel definition layer PDL, a light-emitting structure EMS, and a cathode electrode CE.

On the second insulating layer ISL2, first to third reflective electrodes RE1-RE3 are arranged on first to third sub-pixels SP1-SP3, respectively. The first to third reflective electrodes RE1-RE3 may overlap the first to third light-emitting areas EMA1-EMA3, respectively.

The first to third reflective electrodes RE1-RE3 may contact the circuit elements CCE, respectively, through the first to third via electrodes VIA1-VIA3. The first to third via electrodes VIA1-VIA3 are respectively arranged in the via holes VIAH of the second insulating layer ISL2 between the circuit elements CCE and the first to third reflective electrodes RE1-RE3. Accordingly, each of the first to third via electrodes VIA1-VIA3 may connect the one of the circuit elements CCE and one of the reflective electrodes RE1-RE3 to each other, respectively. Each of the first to third via electrodes VIA1-VIA3 may include at least one of tungsten (W) and copper (Cu), but the present disclosure is not limited thereto.

In one or more embodiments, the circuit elements CCE and the first to third reflective electrodes RE1-RE3 are connected through the first to third via electrodes VIA1-VIA3 and do not make direct contact, so that each of the first to third reflective electrodes RE1-RE3 may have relatively excellent or suitable step coverage. In addition, as described in more detail below, the first to third anode electrodes AE1-AE3 are in direct contact with the first to third reflective electrodes RE1-RE3 through contact holes, respectively, so that if the first to third reflective electrodes RE1-RE3 and the circuit elements CCE were also connected by making direct contact with each other, each of the first to third anode electrodes AE1-AE3 may have relatively smaller step coverage. In other words, because the circuit elements CCE and the first to third reflective electrodes RE1-RE3 are respectively connected through the first to third via electrodes VIA1-VIA3 in one or more embodiments of the present disclosure, each of the first to third reflective electrodes RE1-RE3 may have a relatively planar upper surface, and accordingly, the first to third anode electrodes AE1-AE3 may have relatively excellent or suitable step coverage.

The first to third reflective electrodes RE1-RE3 may function as a full mirror that reflects light emitted from the light-emitting structure EMS toward the display surface (or the cover window CW). The first to third reflective electrodes RE1-RE3 may include metal materials suitable for reflecting light. The first to third reflective electrodes RE1-RE3 may include at least one of titanium (Ti), titanium nitride (TiN), tantalum nitride (TaN), aluminum (Al), and silver (Ag), but the present disclosure is not limited thereto.

Each of the first to third reflective electrodes RE1-RE3 may further include a connection electrode at a lower part. The connection electrode may improve electrical connection characteristics between the reflective electrode and a circuit element CCE of the pixel circuit layer PCL. The connection electrode may have a multilayer structure. The multilayer structure may include titanium (Ti), titanium nitride (TiN), tantalum nitride (TaN), and/or the like, but the present disclosure not limited thereto.

In one or more embodiments, each of the first to third reflective electrodes RE1-RE3 may be in overall contact with (*e.g.,* may be in contact with an entirety or substantially the entirety of) the second insulating layer ISL2. For example, because the first to third reflective electrodes RE1-RE3 are arranged on the second insulating layer ISL2 having a planar upper surface, each of the first to third reflective electrodes RE1-RE3 may also have a relatively planar upper surface. In one or more embodiments, the distances D1, D2, D3 from each of the first to third reflective electrodes RE1-RE3 to the substrate SUB may be substantially the same in the first to third light-emitting areas EMA1-EMA3. In other words, the distance D1 from the first reflective electrode RE1 to the substrate SUB in the first light-emitting area EMA1, the distance D2 from the second reflective electrode RE2 to the substrate SUB in the second light-emitting area EMA2, and the distance D3 from the third reflective electrode RE3 to the substrate SUB in the third light-emitting area EMA3 may be substantially the same.

In one or more embodiments, the inorganic film IOF may be arranged on the first to third reflective electrodes RE1-RE3 and the second insulating layer ISL2. For example, the inorganic film IOF may be arranged between the first to third reflective electrodes RE1-RE3 and the first to third anode electrodes AE1-AE3. The inorganic film IOF may include at least one of silicon oxide (SiOₓ), silicon nitride (SiNₓ), and silicon oxynitride (SiON), but the present disclosure is not limited thereto.

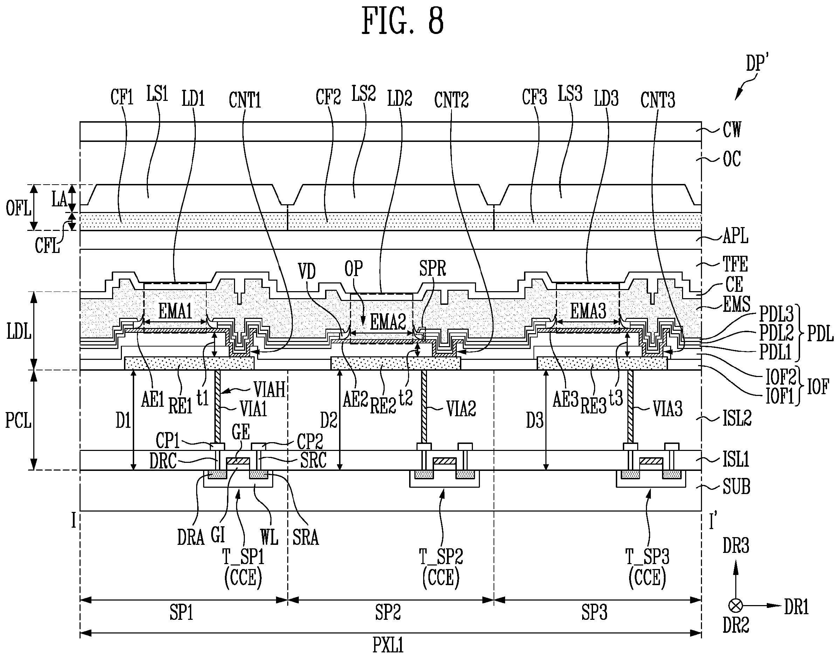

The inorganic film IOF may overlap at least one of the first to third light-emitting areas EMA1-EMA3. For example, the inorganic film IOF may be arranged over all of the first to third reflective electrodes RE1-RE3 (*e.g.,* arranged over an entirety of the first to third reflective electrodes RE1-RE3) (*see, e.g.,* FIG. 8) or may be arranged only on some of the first to third reflective electrodes RE1-RE3 (*see, e.g.,* FIG. 7).

By disposing the inorganic film IOF between the first to third reflective electrodes RE1-RE3 and the first to third anode electrodes AE1-AE3, the height of the anode electrode in the third direction DR3 may be adjusted. For example, by disposing the inorganic film IOF between the first to third anode electrodes AE1-AE3 and the first to third reflective electrodes RE1-RE3, the distance between the anode electrode and the reflective electrode may be adjusted.

In one or more embodiments, the inorganic film IOF may have a different thickness in at least one area among the first to third light-emitting areas EMA1-EMA3 from the remaining areas among the first to third light-emitting areas EMA1-EMA3. In such embodiments, the thickness of the inorganic film IOF for each area refers to the height of the inorganic film IOF in the third direction DR3, and may also include a case where the thickness is 0, *i.e.,* no thickness.

For example, the inorganic film IOF may overlap the first light-emitting area EMA1 and the second light-emitting area EMA2, and may not overlap the third light-emitting area EMA3. For example, the inorganic film IOF may have a thickness of 0 in the third light-emitting area EMA3. In one or more embodiments, the inorganic film IOF may have the largest thickness t1 in the first light-emitting area EMA1, and a smaller thickness t2 in the second light-emitting area EMA2. However, the present disclosure is not limited thereto.

The first to third reflective electrodes RE1-RE3 may function as full mirrors, and the cathode electrode CE may function as a half mirror. For example, each of the first to third reflective electrodes RE1-RE3 and the cathode electrode CE may provide a resonance structure in the corresponding sub-pixel SP. Light emitted from the light-emitting layer of the light-emitting structure EMS may be amplified by going back and forth between the corresponding reflective electrode and the cathode electrode CE, and the amplified light may be output through the cathode electrode CE. As such, the distance between each reflective electrode and the cathode electrode CE may be understood as a resonance distance for light emitted from the light-emitting layer of the corresponding light-emitting structure EMS.

In one or more embodiments, the resonance distance may be adjusted according to the wavelength of light emitted by each of the first to third light-emitting areas EMA1-EMA3. The resonance distance may be proportional to the wavelength of light emitted by each of the first to third light-emitting areas EMA1-EMA3. Accordingly, the inorganic film IOF may have a smaller thickness in an area that emits light with a shorter wavelength among the first to third light-emitting areas EMA1-EMA3. For example, the first to third light-emitting areas EMA1-EMA3 may correspond to red having the longest wavelength, green having the next longest wavelength, and blue having the shortest wavelength, respectively.

The inorganic film IOF overlapping the first light-emitting area EMA1 may have a larger thickness t1 than the other light-emitting areas. Accordingly, the first sub-pixel SP1 including the first light-emitting area EMA1 may have a longer resonance distance than the other sub-pixels due to the inorganic film IOF. The resonance distance of the first sub-pixel SP1 adjusted in this way may enable red color light having the longest wavelength to be amplified effectively and efficiently. Accordingly, the first sub-pixel SP1 may effectively and efficiently output light in the corresponding wavelength range (e.g., red color).

The inorganic film IOF overlapping the third light-emitting area EMA3 may have a thickness of 0. For example, the inorganic film IOF may not overlap the third light-emitting area EMA3. Accordingly, the third sub-pixel SP3 including the third light-emitting area EMA3 may have a shorter resonance distance than the other sub-pixels due to the inorganic film IOF (or lack of the inorganic film IOF). The resonance distance of the third sub-pixel SP3 adjusted in this way (e.g., where the distance, i.e., the resonance distance, between the reflective electrode RE3 and the cathode CE is defined by the thickness of the anode electrode AE3 and the light-emitting structure EMS with no additional thickness due to the inorganic film IOF) may enable blue color light having the shortest wavelength to be amplified effectively and efficiently. Accordingly, the third sub-pixel SP3 may effectively and efficiently output light of the corresponding wavelength range (*e.g.,* blue color).

The inorganic film IOF overlapping the second light-emitting area EMA2 may have a smaller thickness t2 than the first light-emitting area EMA1. Accordingly, the second sub-pixel SP2 including the second light-emitting area EMA2 may have a shorter resonance distance than the first sub-pixel SP1 and a longer resonance distance than the third sub-pixel SP3 due to the inorganic film IOF. The resonance distance of the second sub-pixel SP2 adjusted in this way may enable green color light having an intermediate wavelength to be amplified effectively and efficiently. Accordingly, the second sub-pixel SP2 may effectively and efficiently output light of the corresponding wavelength range (*e.g.,* green color).

In one or more embodiments, by adjusting the thickness of the inorganic film IOF between the anode electrode and the reflective electrode, which overlap each other, the distance between the corresponding anode electrode and the corresponding reflective electrode may be adjusted. Consequently, by adjusting the thickness of the inorganic film IOF, the distance between each reflective electrode and the cathode electrode CE may be adjusted. Accordingly, each of the first to third light-emitting areas EMA1-EMA3 may have an optimal or suitable resonance distance.

The inorganic film IOF can include a first inorganic film IOF1 and a second inorganic film IOF2. The first inorganic film IOF1 may be arranged on the second insulating layer ISL2, and the second inorganic film IOF2 may be arranged on the first inorganic film IOF1. Each of the first inorganic film IOF1 and the second inorganic film IOF2 may include the same material, but the present disclosure is not limited thereto, and in one or more embodiments, each of the first inorganic film IOF1 and the second inorganic film IOF2 may include different materials.

Each of the first inorganic film IOF1 and the second inorganic film IOF2 may overlap at least one of the first to third light-emitting areas EMA1-EMA3. For example, the first inorganic film IOF1 may overlap only the first light-emitting area EMA1 and may not overlap the second and third light-emitting areas EMA2, EMA3. The second inorganic film IOF2 may overlap the first and second light-emitting areas EMA1, EMA2 and may not overlap the third light-emitting area EMA3. However, the present disclosure is not limited thereto.

In one or more embodiments, each of the first inorganic film IOF1 and the second inorganic film IOF2 may have substantially the same thickness across the first to third sub-pixels SP1-SP3. For example, the inorganic film IOF may have different thicknesses across the first to third light-emitting areas EMA1-EMA3 depending on whether the first inorganic film IOF1 and the second inorganic film IOF2 overlap the first to third light-emitting areas EMA1-EMA3, respectively. Accordingly, the thickness t1 of the inorganic film IOF overlapping the first light-emitting area EMA1 where both the first inorganic film IOF1 and the second inorganic film IOF2 are arranged is the largest, the thickness t2 of the inorganic film IOF overlapping the second light-emitting area EMA2 where only the second inorganic film IOF2 is arranged is next largest, and the thickness of the inorganic film IOF in the third light-emitting area EMA3 where neither the first inorganic film IOF1 nor the second inorganic film IOF2 is arranged is 0, so that the third anode electrode AE3 may be in direct contact over all of the third reflective electrode RE3 (*e.g.,* the third electrode AE3 may be in direct contact with an entirety or substantially an entirety of the third reflective electrode RE3 or the third reflective electrode RE3 may be in direct contact with an entirety or substantially an entirety of the third electrode AE3). However, the present disclosure is not limited thereto, and in one or more embodiments, the inorganic film IOF may have a structure in which three or more inorganic films are laminated.

On the inorganic film IOF, first to third anode electrodes AE1-AE3 each overlapping one of the first to third reflective electrodes RE1-RE3, respectively, are arranged. The first to third anode electrodes AE1-AE3 may have shapes substantially the same or similar to the first to third light-emitting areas EMA1-EMA3 of FIG. 6 when viewed in the third direction DR3.

In one or more embodiments, the first to third anode electrodes AE1-AE3 may include at least one transparent conductive material, such as indium tin oxide (ITO), indium zinc oxide (IZO), and/or titanium nitride (TiN). However, the material of the first to third anode electrodes AE1-AE3 is not limited thereto. For example, the first to third anode electrodes AE1-AE3 may include titanium nitride.

The distance between the anode electrode and the reflective electrode, which overlap each other, may be different in at least one area among the first to third light-emitting areas EMA1-EMA3 from the remaining areas among the first to third light-emitting areas EMA1-EMA3. For example, because the inorganic film IOF is arranged between the anode electrode and the reflective electrode, and the thickness of the inorganic film IOF is different in at least one of the first to third light-emitting areas EMA1-EMA3 from the rest of the first to third light-emitting areas EMA1-EMA3, the distance between the overlapping anode electrode and the reflective electrode may be different in at least one area among the first to third light-emitting areas EMA1-EMA3 from the remaining areas of the first to third light-emitting areas EMA1-EMA3. Accordingly, at least one of the first to third anode electrodes AE1-AE3 may have a distance to the substrate SUB which is different from the remaining ones of the first to third anode electrodes AE1-AE3.

For example, in the first light-emitting area EMA1, the distance t1 between the first anode electrode AE1 and the first reflective electrode RE1 may be the longest, in the second light-emitting area EMA2, the distance t2 between the second anode electrode AE2 and the second reflective electrode RE2 may be the next longest, and in the third light-emitting area EMA3, the distance t3 between the third anode electrode AE3 and the third reflective electrode RE3 may be 0. Accordingly, the third anode electrode AE3 may be in contact with the third reflective electrode RE3).

The first to third anode electrodes AE1-AE3 are respectively connected to the first to third reflective electrodes RE1-RE3. In one or more embodiments, the first to third anode electrodes AE1-AE3 may be connected to and in direct contact with the first to third reflective electrodes RE1-RE3 through first to third contact holes CNT1-CNT3 penetrating the inorganic film IOF and overlapping the first to third anode electrodes AE1-AE3, respectively. For example, the first anode electrode AE1 may be directly connected to the first reflective electrode RE1 through the first contact hole CNT1 penetrating the inorganic film IOF. The second anode electrode AE2 may be directly connected to the second reflective electrode RE2 through the second contact hole CNT2 penetrating the inorganic film IOF. The third anode electrode AE3 may be directly connected to the third reflective electrode RE3 through the third contact hole CNT3 penetrating the inorganic film IOF.

A pixel definition layer PDL is arranged on portions of the first to third anode electrodes AE1-AE3 and the inorganic film IOF. The pixel definition layer PDL has an opening OP (*e.g.,* openings OP) that exposes a portion of each of the first to third anode electrodes AE1-AE3. An area overlapping the pixel definition layer PDL may be understood as a boundary area between adjacent sub-pixels SP.

In one or more embodiments, the pixel definition layer PDL may include a plurality of pixel definition films. Each of the plurality of pixel definition films may include at least one of silicon oxide (SiOₓ) and silicon nitride (SiNₓ). For example, the pixel definition layer PDL may include a first pixel definition film PDL1, a second pixel definition film PDL2, and a third pixel definition film PDL3 that are sequentially laminated. The first to third pixel definition films PDL1-PDL3 may include silicon nitride, silicon oxide, and/or silicon nitride, but the present disclosure is not limited thereto.

The pixel definition layer PDL may include a separator SPR in the boundary area between adjacent sub-pixels. The separator SPR may cause a discontinuous portion, such as a void VD, to be formed in the light-emitting structure EMS. Some of the plurality of layers laminated in the light-emitting structure EMS may be disconnected or bent by the voids VD. For example, at least one charge generation layer and at least one hole injection layer included in the light-emitting structure EMS may be disconnected at the voids VD. As such, due to the separator SPR, portions of the light-emitting structure EMS included in the first to third sub-pixels SP1-SP3 may be at least partially separated.

The third pixel definition film PDL3 may have a wider width than the first and second pixel definition films PDL1, PDL2. In such embodiments, side surfaces of the first to third pixel definition films PDL1-PDL3 adjacent to the openings OP may be provided as a separator SPR. For example, during a manufacturing process, the first and second pixel definition films PDL1, PDL2 may be undercut. For example, the third pixel definition film PDL3 may have the shape of eaves on the first and second pixel definition films PDL1, PDL2.

Depending on the shape of the separator SPR, discontinuous portions formed on the light-emitting structure EMS may be variously changed.

The light-emitting structure EMS may be arranged on the anode electrodes AE exposed by the openings OP of the pixel definition layer PDL. The light-emitting structure EMS fills the openings OP of the pixel definition layer PDL and may be arranged over all of the first to third sub-pixels SP1-SP3 across I*(e.g.,* across an entirety or substantially the entirety of the first to third sub-pixels SP1-SP3). The light-emitting structure EMS is formed concurrently (*e.g.,* simultaneously) over all the first to third sub-pixels SP1-SP3 (*e.g.,* across each of, an entirety of, or substantially the entirety of the first to third sub-pixels SP1-SP3) and may have substantially the same thickness across the first to third sub-pixels SP1-SP3.

As described above, the light-emitting structure EMS may be at least partially cut or bent at the boundary area by the separator SPR. Accordingly, if (*e.g.,* when) the display panel DP operates, current flowing from each of the first to third sub-pixels SP1-SP3 to adjacent sub-pixels SP through layers included in the light-emitting structure EMS may be reduced. Therefore, first to third light-emitting elements LD1-LD3 may operate with relatively high reliability.

In one or more embodiments, the light-emitting structure EMS may include two light-emitters that are sequentially laminated, and each of the light-emitters may include a light-emitting layer configured to generate light according to an applied current. In one or more embodiments, the light-emitting structure EMS may include three sequentially laminated light-emitters, and each of the light-emitters may include a light-emitting layer configured to generate light according to an applied current. In such one or more embodiments, a charge generation layer may be arranged between the light emitters.

The light-emitting structure EMS may be formed through a process such as vacuum deposition, inkjet printing, and/or the like.

The cathode electrode CE may be arranged over all the light-emitting structure EMS (*e.g.,* over an entirety or substantially the entirety of the light-emitting structure EMS). The cathode electrode CE may be provided in common to the first to third sub-pixels SP1-SP3. The cathode electrode CE may be formed over all the light-emitting structure EMS (*e.g.,* over an entirety or substantially the entirety of the light-emitting structure EMS) at the same time and may have substantially the same thickness across the first to third sub-pixels SP1-SP3. The cathode electrode CE may function as a half mirror that partially transmits and partially reflects light emitted from the light-emitting structure EMS.

In one or more embodiments, the inorganic film IOF is arranged between the first to third reflective electrodes RE1-RE3 and the first to third anode electrodes AE1-AE3, and has different thicknesses in the first to third light-emitting areas EMA1-EMA3, and the light-emitting structure EMS and the cathode electrode CE have the same thickness over all the first to third light-emitting areas EMA1-EMA3 (*e.g.,* over an entirety or substantially the entirety of the first to third light-emitting areas EMA1-EMA3), so that the distance between each of the first to third reflective electrodes RE1-RE3 and the cathode electrode CE may be different for each light-emitting area.

For example, the distance between the first reflective electrode RE1 and the cathode electrode CE may be longer than the distance between the second reflective electrode RE2 and the cathode electrode CE, and the distance between the second reflective electrode RE2 and the cathode electrode CE may be longer than the distance between the third reflective electrode RE3 and the cathode electrode CE. Accordingly, the distance between each reflective electrode and the cathode electrode CE may be individually adjusted so that each of the first to third light-emitting areas EMA1-EMA3 may have an optimal or suitable resonance distance.

The first anode electrode AE1, a portion of the light-emitting structure EMS overlapping the first anode electrode AE1, and a portion of the cathode electrode CE overlapping the first anode electrode AE1 may form the first light-emitting element LD1. The second anode electrode AE2, a portion of the light-emitting structure EMS overlapping the second anode electrode AE2, and a portion of the cathode electrode CE overlapping the second anode electrode AE2 may form the second light-emitting element LD2. The third anode electrode AE3, a portion of the light-emitting structure EMS overlapping the third anode electrode AE3, and a portion of the cathode electrode CE overlapping the third anode electrode AE3 may form the third light-emitting element LD3.

An encapsulation layer TFE is arranged on the cathode electrode CE. The encapsulation layer TFE may prevent or protect from oxygen and/or moisture penetrating into the light-emitting element layer LDL.

An optical functional layer OFL is arranged on the encapsulation layer TFE. In one or more embodiments, the optical functional layer OFL may be attached to the encapsulation layer TFE through an adhesive layer APL. For example, the optical functional layer OFL may be manufactured separately and attached to the encapsulation layer TFE through the adhesive layer APL. The adhesive layer APL may further perform a function of protecting lower layers including the encapsulation layer TFE.

The optical functional layer OFL may include a color filter layer CFL and a lens array LA. The color filter layer CFL may include first to third color filters CF1-CF3 corresponding to the first to third sub-pixels SP1-SP3, respectively. The first to third color filters CF1-CF3 may be configured to transmit light of different wavelength ranges. For example, the first to third color filters CF1-CF3 may be configured to transmit light of red, green, and blue colors, respectively.

In one or more embodiments, the first to third color filters CF1-CF3 may partially overlap in the boundary area. In one or more embodiments, the first to third color filters CF1-CF3 may be spaced and/or apart (*e.g.,* spaced apart or separated) from each other, and a black matrix may be provided between the first to third color filters CF1-CF3.

The lens array LA is arranged on the color filter layer CFL. The lens array LA may include first to third lenses LS1-LS3 corresponding to the first to third sub-pixels SP1-SP3, respectively. The first to third lenses LS1-LS3 may output light emitted from the first to third light-emitting elements LD1-LD3 to an intended path, thereby improving light emission efficiency.

An overcoat layer OC may be arranged on the lens array LA. The overcoat layer OC is configured to protect its lower layers from foreign substances, such as dust and moisture. A cover window CW may be arranged on the overcoat layer OC.

In one or more embodiments, the inorganic film IOF is arranged between the first to third reflective electrodes RE1-RE3 and the first to third anode electrodes AE1-AE3, and has a different thickness in at least one area among the first to third light-emitting areas EMA1-EMA3 from the remaining areas of the first to third light-emitting areas EMA1-EMA3, such that the distance between each of the first to third reflective electrodes RE1-RE3 and the cathode electrode CE may be different for each light-emitting area. For example, by adjusting the distance between each of the first to third reflective electrodes RE1-RE3 and the cathode electrode CE by the inorganic film IOF, the resonance distance for light emitted from the light-emitting layer of the corresponding light-emitting structure EMS may be adjusted.

In one or more embodiments, by adjusting the thickness of the inorganic film IOF without planarizing the inorganic film IOF, it may be easy to control the thickness of the inorganic film IOF, *i.e.*, the dispersion in the resonance distance. For example, partial brightness reduction in the display device due to dispersion in the resonance distance may be prevented or reduced, and thus the overall brightness of the display device may be improved.

FIG. 8 is a cross-sectional diagram taken along the line I-I' of FIG. 6, according to one or more embodiments of the present disclosure.

A display panel DP' according to the present embodiments is different from the display panel DP of the aforementioned FIG. 7 in the thickness of the inorganic film IOF overlapping the first to third light-emitting areas EMA1-EMA3, respectively. Therefore, any content or description that may overlap the aforementioned content and/or description will be briefly described or may not be repeated.

Referring to FIG. 8, a pixel circuit layer PCL is arranged on a substrate SUB, and first to third reflective electrodes RE1-RE3 are arranged on the pixel circuit layer PCL. The substrate SUB, the pixel circuit layer PCL, and the first to third reflective electrodes RE1-RE3 of FIG. 8 are configured substantially the same or similarly to the substrate SUB, the pixel circuit layer PCL, and the first to third reflective electrodes RE1-RE3 of FIG. 7, respectively.

An inorganic film IOF is arranged on the first to third reflective electrodes RE1-RE3 and a second insulating layer ISL2. The inorganic film IOF may have a different thickness in at least one area among first to third light-emitting areas EMA1-EMA3 from the remaining areas of first to third light-emitting areas EMA1-EMA3.

For example, the inorganic film IOF may overlap over all the first to third light-emitting areas EMA1-EMA3 (*e.g.,* may overlap each of, an entirety of, or substantially the entirety of the first to third light-emitting areas EMA1-EMA3). In one or more embodiments, the inorganic film IOF may have the same thickness in only two areas among the first to third light-emitting areas EMA1-EMA3. For example, the inorganic film IOF may have the same thickness t1, t3 in the first and third light-emitting areas EMA1, EMA3 and may have a smaller thickness t2 in the second light-emitting area EMA2.

In one or more embodiments, the resonance distance may be adjusted to match the wavelength of light emitted by each of the first to third light-emitting areas EMA1-EMA3. The resonance distance may be proportional to the wavelength of light emitted by each of the first to third light-emitting areas EMA1-EMA3. Therefore, if (*e.g.,* when) the thickness t1 of the inorganic film IOF overlapping the first light-emitting area EMA1 and the thickness t3 of the inorganic film IOF overlapping the third light-emitting area EMA3 are substantially the same, the resonance distance of each of the first and third light-emitting areas EMA1, EMA3 may be proportional to the least common multiple of the wavelength of light emitted by the first light-emitting area EMA1 and the wavelength of light emitted by the third light-emitting area EMA3.

The inorganic film IOF may include a first inorganic film IOF1 and a second inorganic film IOF2. Each of the first inorganic film IOF1 and the second inorganic film IOF2 may overlap at least one area among the first to third light-emitting areas EMA1-EMA3.

For example, the first inorganic film IOF1 may overlap only the first and third light-emitting areas EMA1, EMA3 and may not overlap the second light-emitting area EMA2. The second inorganic film IOF2 may overlap over all the first to third light-emitting areas EMA1-EMA3 (*e.g.,* may overlap each of, an entirety of, or substantially the entirety of the first to third light-emitting areas EMA1-EMA3). In such embodiments, each of the first inorganic film IOF1 and the second inorganic film IOF2 may have substantially the same thickness across the first to third sub-pixels SP1-SP3. For example, the inorganic film IOF may have different thicknesses in the first to third light-emitting areas EMA1-EMA3 depending on whether the first inorganic film IOF1 and/or the second inorganic film IOF2 overlap the first to third light-emitting areas EMA1-EMA3, respectively. Accordingly, the thicknesses t1, t3 of the inorganic film IOF overlapping the first and third light-emitting areas EMA1, EMA3 in which both the first inorganic film IOF1 and the second inorganic film IOF2 are arranged may be the largest, and the thickness t2 of the inorganic film IOF overlapping the second light-emitting area EMA2 in which only the second inorganic film IOF2 is arranged may be the smallest.

First to third anode electrodes AE1-AE3, each overlapping the first to third reflective electrodes RE1-RE3, are arranged on the inorganic film IOF.

The distance between the anode electrode and the reflective electrode overlapping each other may be different in at least one area among the first to third light-emitting areas EMA1-EMA3 from the remaining areas of the first to third light-emitting areas EMA1-EMA3. For example, in each of the first and third light-emitting areas EMA1, EMA3, the distance t1, t3 between the anode electrode and the reflective electrode overlapping each other may be the largest, and in the second light-emitting area EMA2, the distance t2 between the second anode electrode AE2 and the second reflective electrode RE2 may be the smallest.

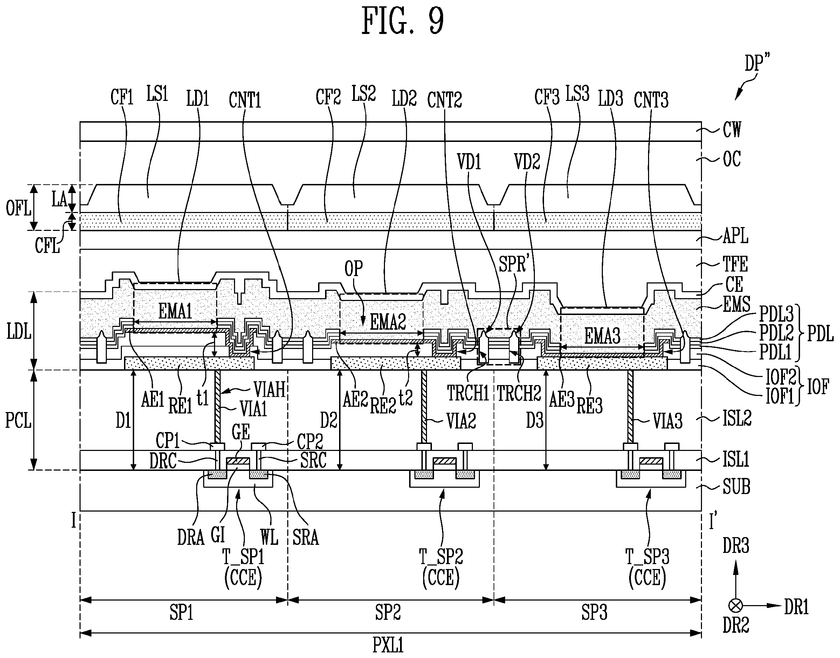

FIG. 9 is a cross-sectional diagram taken along the line I-I' of FIG. 6, according to one or more embodiments of the present disclosure.

A display panel DP" according to the present embodiments is different from the display panel DP of the aforementioned FIG. 7 in the shape of the separator. Therefore, any content that may overlap the aforementioned content and/or description will be briefly described or may not be repeated.

Referring to FIG. 9, a pixel circuit layer PCL is arranged on a substrate SUB, and first to third reflective electrodes RE1-RE3 and first to third anode electrodes AE1-AE3 are arranged on the pixel circuit layer PCL. The substrate SUB, the pixel circuit layer PCL, the first to third reflective electrodes RE1-RE3, and the first to third anode electrodes AE1-AE3 of FIG. 8 are configured substantially the same or similarly to the substrate SUB, the pixel circuit layer PCL, the first to third reflective electrodes RE1-RE3, and the first to third anode electrodes AE1-AE3 of FIG. 7, respectively.

A pixel definition layer PDL is arranged on portions of the first to third anode electrodes AE1-AE3 and an inorganic film IOF. The pixel definition layer PDL may include a separator SPR' in a boundary area between adjacent sub-pixels SP. For example, the separator SPR' may be provided in each of the boundary areas between the sub-pixels SP of FIG. 4.

The separator SPR' may cause a discontinuous portion to be formed in a light-emitting structure EMS in the boundary area. For example, the light-emitting structure EMS may be disconnected or bent in the boundary area by the separator SPR'. Accordingly, the first to third light-emitting areas EMA1-EMA3 of FIG. 6, which respectively correspond to the first to third sub-pixels SP1-SP3, may be defined according to the separator SPR' of the pixel definition layer PDL.

The separator SPR' may be provided in or on the pixel definition layer PDL. The pixel definition layer PDL may include one or more trenches TRCH1, TRCH2 as the separator SPR' in the boundary area. In one or more embodiments, the one or more trenches TRCH1, TRCH2 may penetrate the pixel definition layer PDL and partially penetrate the inorganic film IOF, as illustrated in FIG. 7. In one or more embodiments, the one or more trenches TRCH1, TRCH2 may penetrate the pixel definition layer PDL and the inorganic film IOF and partially penetrate the second insulating layer ISL2. In one or more embodiments, the one or more trenches TRCH1, TRCH2 at least partially penetrate the second insulating layer ISL2 and/or the first insulating layer ISL1, and a portion of the pixel definition layer PDL may be arranged within the one or more trenches TRCH1, TRCH2.

In FIG. 9, two trenches TRCH1, TRCH2 are illustrated as being provided in the boundary area. However, the present disclosure is not limited thereto. For example, the pixel definition layer PDL may include one trench in the boundary area. Alternatively, in one or more embodiments, the pixel definition layer PDL may include three or more trenches in the boundary area.

Due to the first and second trenches TRCH1, TRCH2, discontinuous portions, such as a first void VD1 and a second void VD2, may be formed in the light-emitting structure EMS in the boundary area. Some of the plurality of layers laminated within the light-emitting structure EMS may be disconnected or bent by the first and second voids VD1, VD2. For example, at least one charge generation layer and at least one hole injection layer included in the light-emitting structure EMS may be disconnected by the first and second voids VD1, VD2. As such, due to the first and second trenches TRCH1, TRCH2, portions of the light-emitting structure EMS included in the first to third sub-pixels SP1-SP3 may be at least partially separated.

Depending on the shapes of the first and second trenches TRCH1, TRCH2, the discontinuous portions formed in the light-emitting structure EMS may vary.

The pixel definition layer PDL may include an additional separator so that the light-emitting structure EMS further includes a discontinuous portion adjacent to the boundary area. In one or more embodiments, the uppermost third pixel definition film PDL3 among first to third pixel definition films PDL1-PDL3 of the pixel definition layer PDL may have a wider width than the second inorganic insulating layer ISL2 arranged underneath it. For example, the pixel definition layer PDL may have a cross-section of a "T" shape or an "I" shape in the boundary area BDA. Depending on the shape of the pixel definition layer PDL, the plurality of layers included in the light-emitting structure EMS may be at least partially disconnected or bent in the boundary area BDA or in the area adjacent to the boundary area BDA.

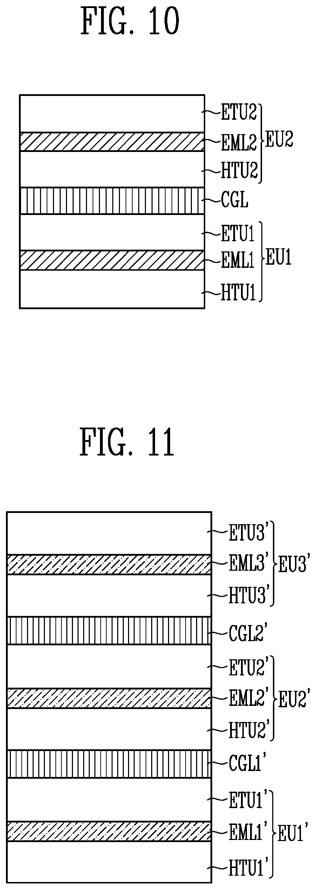

FIG. 10 is a cross-sectional diagram illustrating a portion of a light-emitting structure of one of the first to third light-emitting elements of FIG. 7, FIG. 8, or FIG. 9, according to one or more embodiments of the present disclosure.

Referring to FIG. 10, the light-emitting structure may have a tandem structure in which first and second light-emitters EU1, EU2 are laminated. The light-emitting structure may be configured substantially identically in each or any of the first to third light-emitting elements LD1-LD3 of FIG. 7, FIG. 8 and/or FIG. 9.

Each of the first and second light-emitters EU1, EU2 may include at least one light-emitting layer that generates light according to an applied current. The first light-emitter EU1 may include a first light-emitting layer EML1, a first electron transporter ETU1, and a first hole transporter HTU1. The first light-emitting layer EML1 may be arranged between the first electron transporter ETU1 and the first hole transporter HTU1. The second light-emitter EU2 may include a second light-emitting layer EML2, a second electron transporter ETU2, and a second hole transporter HTU2. The second emitting layer EML2 may be arranged between the second electron transporter ETU2 and the second hole transporter HTU2.

Each of the first and second hole transporters HTU1, HTU2 may include at least one of a hole injection layer and/or a hole transport layer, and may further include a hole buffer layer, an electron blocking layer, and/or the like, as desired and//or needed. The first and second hole transporters HTU1, HTU2 may have the same configuration or different configurations.

Each of the first and second electron transporters ETU1, ETU2 may include at least one of an electron injection layer and/or an electron transport layer, and may further include an electron buffer layer, a hole blocking layer, and/or the like, as desired and/or needed. The first and second electron transporters ETU1, ETU2 may have the same configuration or different configurations.

A connecting layer, which may be provided in the form of a charge generation layer CGL, may be arranged between the first light-emitter EU1 and the second light-emitter EU2 to connect them to each other. In one or more embodiments, the charge generation layer CGL may have a laminated structure of a p-dopant layer and an n-dopant layer. For example, the p-dopant layer may include a p-type kind dopant such as dipyrazino[2,3-f: 2',3'-h] quinoxaline-2,3,6,7,10,11-hexacarbonitrile (HAT-CN), tetracyanoquinodimethane (TCNQ), 2-(7-dicyanomethylene-1,3,4,5,6,8,9,10-octafluoro-7H-pyrene-2-ylidene)-malononitrile NDP-9), and/or the like, and the n-dopant layer may include an alkali metal, an alkaline earth metal, a lanthanide metal, and/or a (*e.g.,* any suitable) combination thereof. However, the present disclosure is not limited thereto.

In one or more embodiments, the first light-emitting layer EML1 and the second light-emitting layer EML2 may generate light of different colors. Light emitted from each of the first light-emitting layer EML1 and the second light-emitting layer EML2 may be mixed and viewed as white light. For example, the first light-emitting layer EML1 may generate blue color light, and the second light-emitting layer EML2 may generate yellow color light. In one or more embodiments, the second light-emitting layer EML2 may include a structure in which a first sub-light-emitting layer configured to generate red color light and a second sub-light-emitting layer configured to generate green color light are laminated. The red color light and the green color light may be mixed to provide yellow color light. In this case, an intermediate layer configured to perform a function of transporting holes and/or a function of blocking the transport of electrons may be further arranged between the first and second sub-light-emitting layers.

In one or more embodiments, the first light-emitting layer EML1 and the second light-emitting layer EML2 may generate light of the same color.

The light-emitting structure may be formed by a method such as vacuum deposition, inkjet printing, and/or the like, but the present disclosure is not limited thereto.

FIG. 11 is a cross-sectional diagram illustrating a portion of a light-emitting structure of one of the first to third light-emitting elements of FIG. 7, FIG. 8, or FIG. 9, according to one or more embodiments of the present disclosure.

Referring to FIG. 11, the light-emitting structure may have a tandem structure in which first to third light-emitters EU1'-EU3' are laminated. The light-emitting structure may be configured substantially identically in each or any of the first to third light-emitting elements LD1-LD3 of FIG. 7, FIG. 8 and/or FIG. 9.

Each of the first to third light-emitters EU1'-EU3' may include a light-emitting layer that generates light according to an applied current. The first light-emitter EU1' may include a first light-emitting layer EML1', a first electron transporter ETU1', and a first hole transporter HTU1'. The first light-emitting layer EML1' may be arranged between the first electron transporter ETU1' and the first hole transporter HTU1'. The second light-emitter EU2' may include a second light-emitting layer EML2', a second electron transporter ETU2', and a second hole transporter HTU2'. The second light-emitting layer EML2' may be arranged between the second electron transporter ETU2' and the second hole transporter HTU2'. The third light-emitter EU3' may include a third light-emitting layer EML3', a third electron transporter ETU3', and a third hole transporter HTU3'. The third light-emitting layer EML3' may be arranged between the third electron transporter ETU3' and the third hole transporter HTU3'.

Each of the first to third hole transporters HTU1'-HTU3' may include at least one of a hole injection layer and/or a hole transport layer, and may further include a hole buffer layer, an electron blocking layer, and/or the like, as desired and/or needed. The first to third hole transporters HTU1'-HTU3' may have the same configuration or different configurations.

Each of the first to third electron transporters ETU1'-ETU3' may include at least one of an electron injection layer and/or an electron transport layer, and may further include an electron buffer layer, a hole blocking layer, and/or the like, as desired and/or needed. The first to third electron transporters ETU1'-ETU3' may have the same configuration or different configurations.

A first charge generation layer CGL1' is arranged between the first light-emitter EU1' and the second light-emitter EU2'. A second charge generation layer CGL2' is arranged between the second light-emitter EU2' and the third light-emitter EU3'.

In one or more embodiments, the first to third light-emitting layers EML1'-EML3' may generate light of different colors. Light emitted from each of the first to third light-emitting layers EML1'-EML3' may be mixed and viewed as white light. For example, the first light-emitting layer EML1' may generate blue color light, the second light-emitting layer EML2' may generate green color light, and the third light-emitting layer EML3' may generate red color light.

In one or more embodiments, two or more of the first to third light-emitting layers EML1'-EML3' may generate light of the same color.

Unlike as illustrated in FIGS. 10 and 11, the light-emitting structure of FIG. 7, FIG. 8, or FIG. 9 may include one light-emitter in each of the first to third light-emitting elements LD1-LD3. At this time, the light-emitters included in each of the first to third light-emitting elements LD1-LD3 may be configured to emit light of different colors. For example, the light-emitter of the first light-emitting element LD1 may be to emit red color light, the light-emitter of the second light-emitting element LD2 may be to emit green color light, and the light-emitter of the third light-emitting element LD3 may be to emit blue color light. In such embodiments, the light emitters of the first to third sub-pixels SP1-SP3 may be separated from each other, and each of them may be arranged within an opening *see, e.g.,* OP of FIG. 7 and OP' of FIG. 8 of a pixel definition layer *see, e.g.,* PDL of FIG. 7 and PDL' of FIG. 8. In such embodiments, at least some of the color filters CF1-CF3 may not be provided.

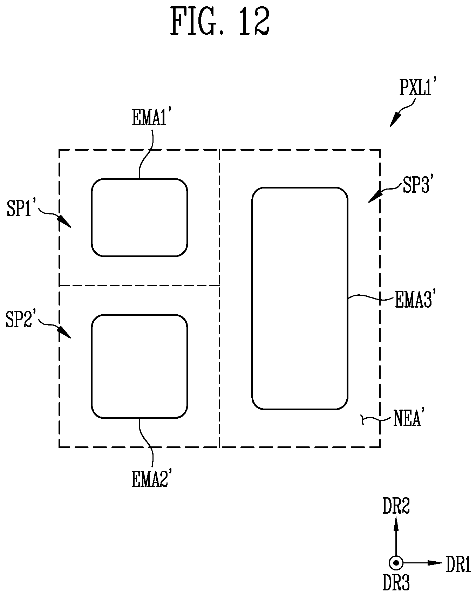

FIG. 12 is a plan view illustrating a pixel of FIG. 5, according to one or more embodiments of the present disclosure. The remaining pixels may be configured substantially the same or similarly to the first pixel PXL1'.

Referring to FIG. 12, a first pixel PXL1' may include first to third sub-pixels SP1'-SP3'.

The first sub-pixel SP1' may include a first light-emitting area EMA1' and a non-emitting area NEA' around the first light-emitting area EMA1'. The second sub-pixel SP2' may include a second light-emitting area EMA2' and the non-emitting area NEA' around the second light-emitting area EMA2'. The third sub-pixel SP3' may include a third light-emitting area EMA3' and the non-emitting area NEA' around the third light-emitting area EMA3'.

The first sub-pixel SP1' and the second sub-pixel SP2' may be arranged in the second direction DR2. The third sub-pixel SP3' may be arranged in the first direction DR1 with respect to each of the first and second sub-pixels SP1', SP2'.

The second sub-pixel SP2' may have a larger area than the first sub-pixel SP1', and the third sub-pixel SP3' may have a larger area than the second sub-pixel SP2'. Accordingly, the second light-emitting area EMA2' may have a larger area than the first light-emitting area EMA1', and the third light-emitting area EMA3' may have a larger area than the second light-emitting area EMA2'. However, the present disclosure is not limited thereto. For example, the first and second sub-pixels SP1', SP2' may have substantially the same area, and the third sub-pixel SP3' may have a larger area than each of the first and second sub-pixels SP1', SP2'. As such, the areas of the first to third sub-pixels SP1'-SP3' may be varied in one or more suitable ways depending on the embodiments.

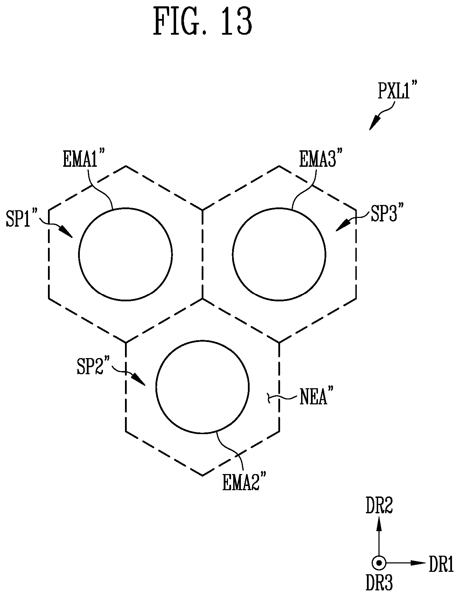

FIG. 13 is a plan view illustrating a pixel of FIG. 5, according to one or more embodiments of the present disclosure. The remaining pixels may be configured substantially the same or similarly to the first pixel PXL1".

Referring to FIG. 13, a first sub-pixel SP1" may include a first light-emitting area EMA1" and a non-emitting area NEA" around the first light-emitting area EMA1". The second sub-pixel SP2" may include a second light-emitting area EMA2" and the non-emitting area NEA" around the second light-emitting area EMA2". The third sub-pixel SP3" may include a third light-emitting area EMA3" and the non-emitting area NEA" around the third light-emitting area EMA3".

The first to third sub-pixels SP1"-SP3" may have polygonal shapes when viewed in the third direction DR3. For example, the shapes of the first to third sub-pixels SP1"-SP3" may be hexagons, as illustrated in FIG. 13.

The first to third light-emitting areas EMA1"-EMA3" may have circular shapes when viewed in the third direction DR3. However, the present disclosure is not limited thereto. For example, each of the first to third light-emitting areas EMA1"-EMA3" may have a polygonal shape.

The first and third sub-pixels SP1", SP3" may be arranged in the first direction DR1. The second sub-pixel SP2" may be arranged in a direction inclined at an acute angle (or diagonal direction) with respect to the first sub-pixel SP1" based on the second direction DR2.

The arrangement of the sub-pixels illustrated in FIGS. 6, 12, and 13 are example embodiments, and the present disclosure is not limited thereto. Each pixel includes two or more sub-pixels, the sub-pixels may be arranged in one or more suitable ways, each of the sub-pixels may have one or more suitable shapes, and each of the light-emitting areas thereof may also have one or more suitable shapes.

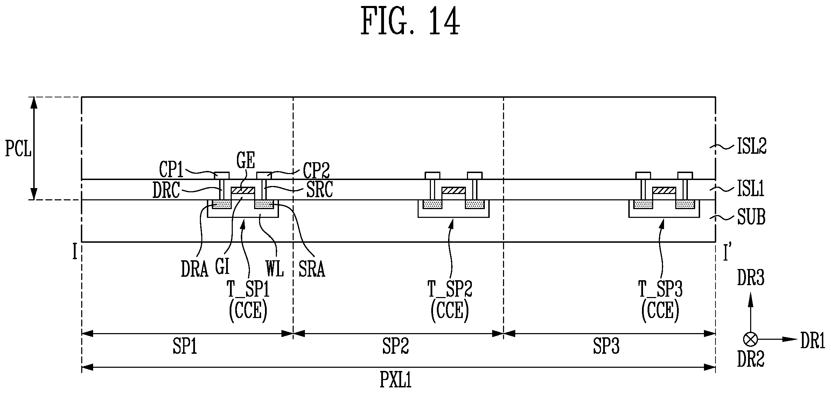

FIGS. 14 to 25 are diagrams illustrating a method of manufacturing a display device according to one or more embodiments of the present disclosure. FIGS. 14 to 25 illustrate a method of manufacturing a display device according to the above-described embodiment with reference to FIGS. 1 to 7. Any content or description that may overlap the above-described content and/or description will be briefly described or may not be repeated.

Referring to FIG. 14, a pixel circuit layer PCL may be formed on a substrate SUB.

For example, a first insulating layer ISL1 and circuit elements CCE of each of first to third sub-pixels SP1-SP3 may be formed on the substrate SUB. The substrate SUB and the circuit elements CCE may include a transistor T_SP1 of the first sub-pixel SP1, a transistor T_SP2 of the second sub-pixel SP2, and a transistor T_SP3 of the third sub-pixel SP3.

A second insulating layer ISL2 may be formed on the first insulating layer ISL1 to cover the circuit elements CCE. Accordingly, the pixel circuit layer PCL including the circuit elements CCE, the first insulating layer ISL1, and the second insulating layer ISL2 may be formed.

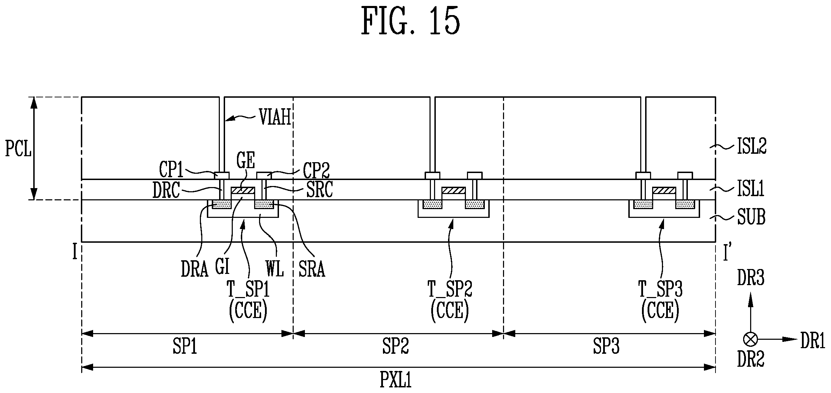

Referring to FIG. 15, via holes VIAH may be formed in the second insulating layer ISL2. The via holes VIAH may penetrate the second insulating layer ISL2 and overlap the circuit elements CCE, respectively. For example, each of the via holes VIAH may expose a portion of an upper surface of the circuit element CCE.

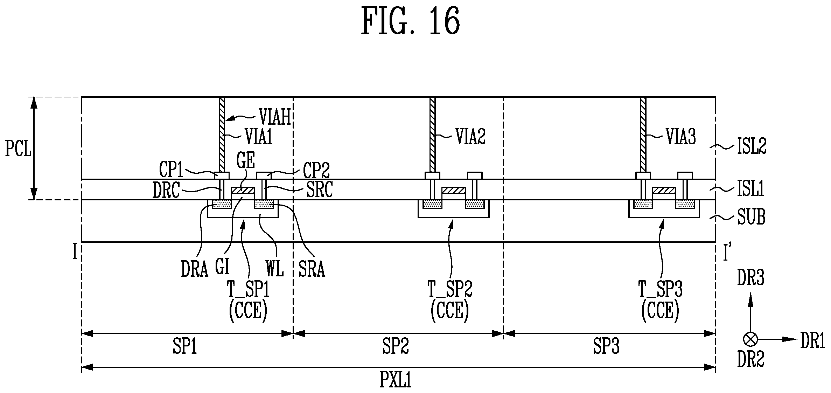

Referring to FIG. 16, first to third via electrodes VIA1-VIA3 may be formed in the via holes VIAH of the second insulating layer ISL2, respectively. The first to third via electrodes VIA1-VIA3 may be connected to and in contact with the circuit elements CCE exposed by the via holes VIAH, respectively. Each of the first to third via electrodes VIA1-VIA3 may be formed of at least one of tungsten (W) and copper (Cu), but the present disclosure is not limited thereto.

In one or more embodiments, after the first to third via electrodes VIA1-VIA3 are formed, the second insulating layer ISL2 and the first to third via electrodes VIA1-VIA3 may be planarized through a polishing process. For example, the upper surfaces of the second insulating layer ISL2 and each of the first to third via electrodes VIA1-VIA3 may be planarized through the polishing process, so that the second insulating layer ISL2 may have a planar upper surface. In such embodiments, the polishing process may be a chemical mechanical planarization (CMP) process.

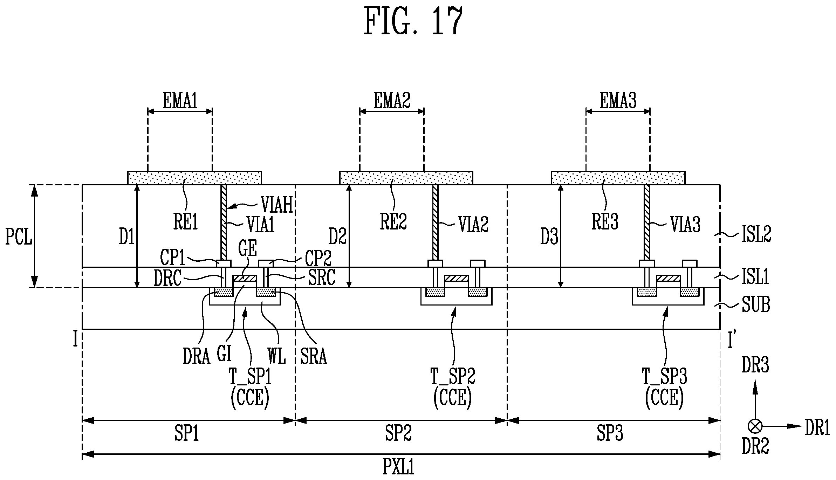

Referring to FIG. 17, first to third reflective electrodes RE1-RE3 may be formed on the second insulating layer ISL2. The first to third reflective electrodes RE1-RE3 may be formed to overlap the first to third light-emitting areas EMA1-EMA3, respectively, and may be connected to the first to third via electrodes VIA1-VIA3, respectively.

Each of the first to third reflective electrodes RE1-RE3 may be formed so as to make contact with (e.g., each of the first to third reflective electrodes RE1-RE3 may be in direct contact with) the second insulating layer ISL2 on the second insulating layer ISL2. Because the second insulating layer ISL2 has a planar upper surface, the distances D1, D2, D3 from each of the first to third reflective electrodes RE1-RE3 arranged on the second insulating layer ISL2 to the substrate SUB may be formed to be the same.

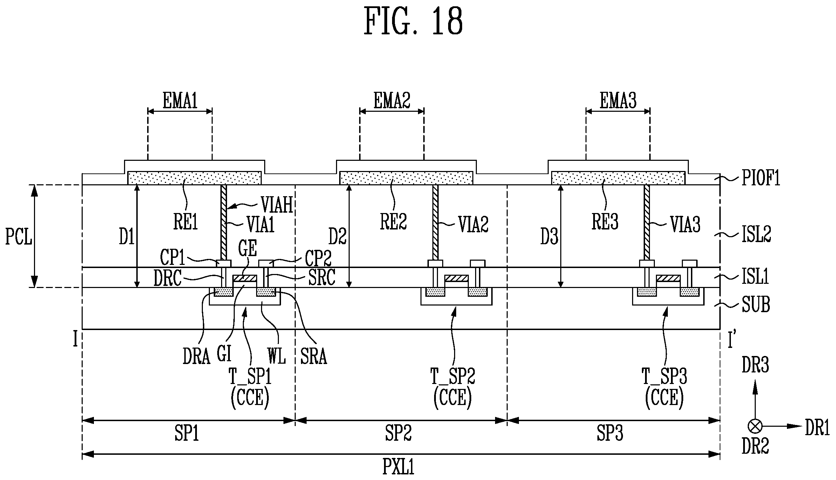

Referring to FIGS. 18 to 21, an inorganic film IOF may be formed on the first to third reflective electrodes RE1-RE3. The inorganic film IOF may include a first inorganic film IOF1 and a second inorganic film IOF2 arranged on the first inorganic film IOF1.

Referring to FIG. 18, a first preliminary inorganic film PIOF1 may be formed over all of the second insulating layer ISL2 and the first to third reflective electrodes RE1-RE3 (e.g., may be formed on an entirety or substantially the entirety of the second insulating layer ISL2 and the first to third reflective electrodes RE1-RE3). The first preliminary inorganic film PIOF1 may be formed of at least one of silicon oxide (SiOₓ), silicon nitride (SiNₓ), and/or silicon oxynitride (SiON), but the present disclosure is not limited thereto.

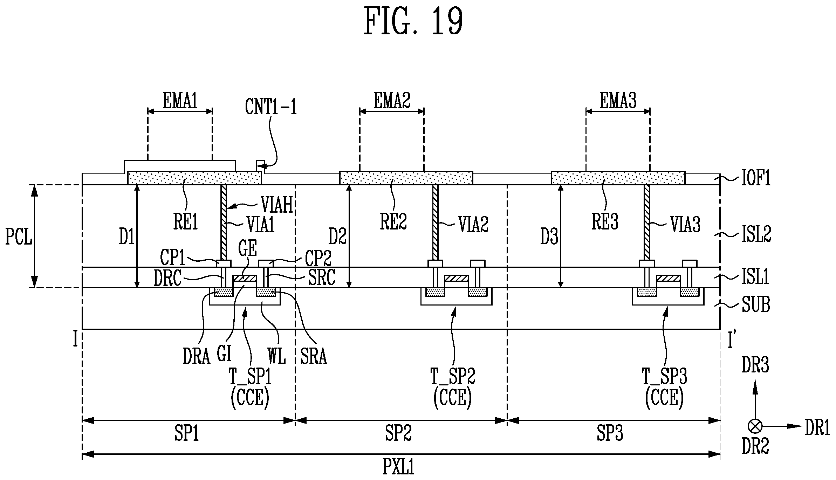

Referring to FIG. 19, the first preliminary inorganic film PIOF1 may be partially removed to form the first inorganic film IOF1.

For example, first portions overlapping two of the first to third light-emitting areas EMA1-EMA3 in the first preliminary inorganic film PIOF1 may be removed. In one or more embodiments, a contact hole may be formed in a portion adjacent to the light-emitting area of the remaining one among the first preliminary inorganic films PIOF1 at the same time. For example, first portions of the first preliminary inorganic film PIOF1 overlapping the second and third light-emitting areas EMA2, EMA3 may be removed, and a first-first contact hole CNT1-1 may be formed in a portion adjacent to the first light-emitting area EMA1 and overlapping the first reflective electrode RE1. Accordingly, the first inorganic film IOF1 may overlap the first light-emitting area EMA1 and boundary areas between neighboring sub-pixels.

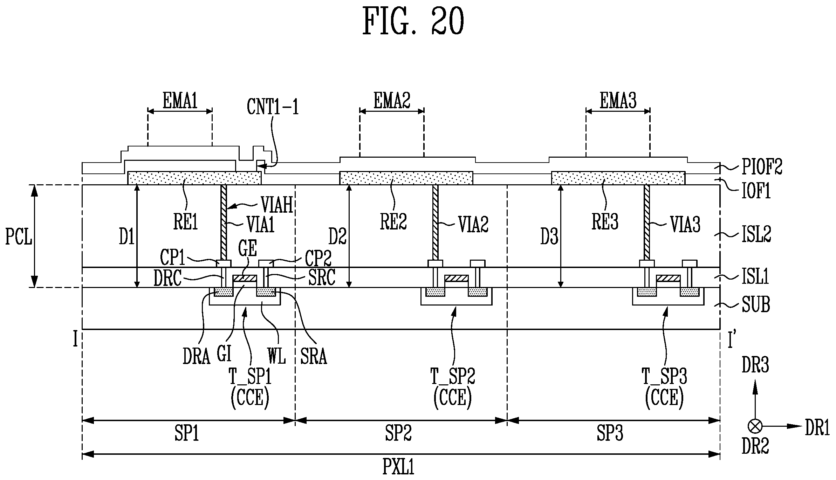

Referring to FIG. 20, a second preliminary inorganic film PIOF2 may be formed over all of the first inorganic film IOF1 (e.g., may be formed on an entirety or substantially the entirety of the first inorganic film IOF1). The second preliminary inorganic film PIOF2 may be formed of at least one of silicon oxide (SiOₓ), silicon nitride (SiNₓ), and/or silicon oxynitride (SiON), but the present disclosure is not limited thereto. In one or more embodiments, the second preliminary inorganic film PIOF2 may be formed of the same material as the first preliminary inorganic film PIOF1, but the present disclosure is not limited thereto.

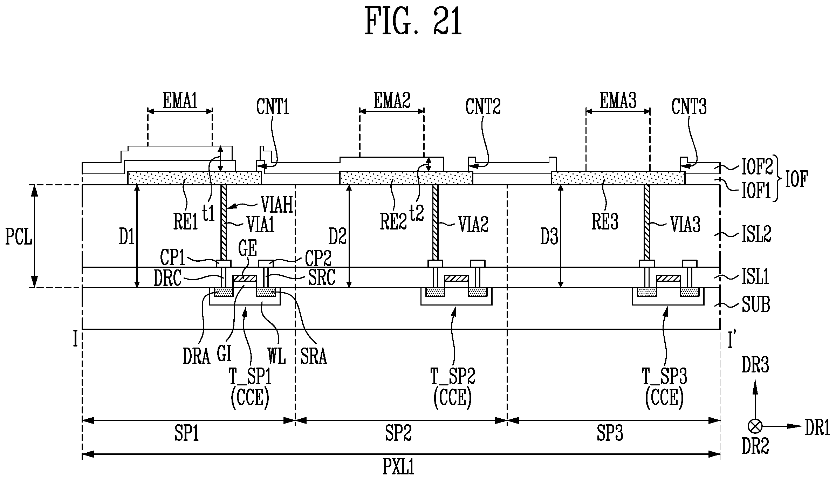

Referring to FIG. 21, the second preliminary inorganic film PIOF2 may be partially removed to form the second inorganic film IOF2.

For example, a second portion of the second preliminary inorganic film PIOF2 overlapping one light-emitting area may be removed. In one or more embodiments, at the same time, contact holes may be formed in the portions of the second preliminary inorganic film PIOF2 adjacent to the remaining two light-emitting areas, respectively. For example, the second portion of the second preliminary inorganic film PIOF2 overlapping the third light-emitting area EMA3 may be removed, and the removal will both remove the second preliminary inorganic film PIOF2 in the third light emitting area EMA3 while also forming a third contact hole CNT3. In addition, first and second contact holes CNT1, CNT2 may be formed in portions adjacent to the first and second light-emitting areas EMA1, EMA2 respectively and overlapping the first and second reflective electrodes RE1, RE2, respectively. In such embodiments, the first contact hole CNT1 includes the first-first contact hole CNT1-1 and may be formed in a portion overlapping the first-first contact hole CNT1-1. Accordingly, the second inorganic film IOF2 may overlap the first and second light-emitting areas EMA1, EMA2 and boundary areas between neighboring sub-pixels.

In one or more embodiments, each of the first inorganic film IOF1 and the second inorganic film IOF2 may be partially removed for each light-emitting area, so that the thickness of the inorganic film IOF overlapping each light-emitting area may be adjusted. Accordingly, the thickness t1 of the inorganic film IOF overlapping the first light-emitting area EMA1 may be the largest, the thickness t2 of the inorganic film IOF overlapping the second light-emitting area EMA2 may be the second largest, and the thickness of the inorganic film IOF overlapping the third light-emitting area EMA3 may be 0. In addition, because the portion of the inorganic film IOF overlapping the third light-emitting area EMA3 is completely removed, a third contact hole CNT3 overlapping over all of the third light-emitting area EMA3 (e.g., overlapping an entirety or substantially the entirety of the third light-emitting area EMA3) may be formed in the inorganic film IOF. However, the present disclosure is not limited thereto, and in one or more embodiments, the inorganic film IOF may have the same thickness in two areas among the first to third light-emitting areas EMA1-EMA3 see, e.g., FIG. 8, and in one or more embodiments, the lamination order of the first inorganic film IOF1 and the second inorganic film IOF2 may be reversed.

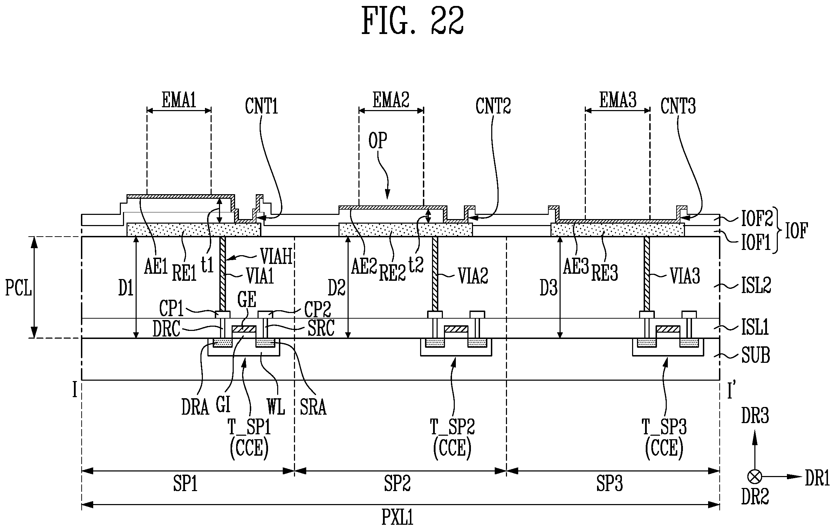

Referring to FIG. 22, first to third anode electrodes AE1-AE3 may be formed on the inorganic film IOF. The first to third anode electrodes AE1-AE3 may be formed to overlap the first to third reflective electrodes RE1-RE3, respectively. In one or more embodiments, the first to third anode electrodes AE1-AE3 may be formed to directly contact the first to third reflective electrodes RE1-RE3, respectively, through first to third contact holes CNT1-CNT3 formed in the inorganic film IOF.

The distance between the reflective electrode and the anode electrode overlapping the reflective electrode may be formed differently in at least one area among the first to third light-emitting areas EMA1-EMA3 from the remaining areas of the first to third light-emitting areas EMA1-EMA3 due to the inorganic film IOF. For example, the distance from the anode electrode to the substrate SUB may be formed differently in at least one area among the first to third light-emitting areas EMA1-EMA3 from the remaining areas of the first to third light-emitting areas EMA1-EMA3.

For example, the distance t1 from the first anode electrode AE1 to the first reflective electrode RE1 may be formed to be the longest, the distance t2 from the second anode electrode AE2 to the second reflective electrode RE2 may be formed to be the second longest, and the distance t3 from the third anode electrode AE3 to the third reflective electrode RE3 may be formed to be the shortest. For example, the distance from the first anode electrode AE1 to the substrate SUB may be formed to be the longest, the distance from the second anode electrode AE2 to the substrate SUB may be formed to be the second longest, and the distance from the third anode electrode AE3 to the substrate SUB may be formed to be the shortest.

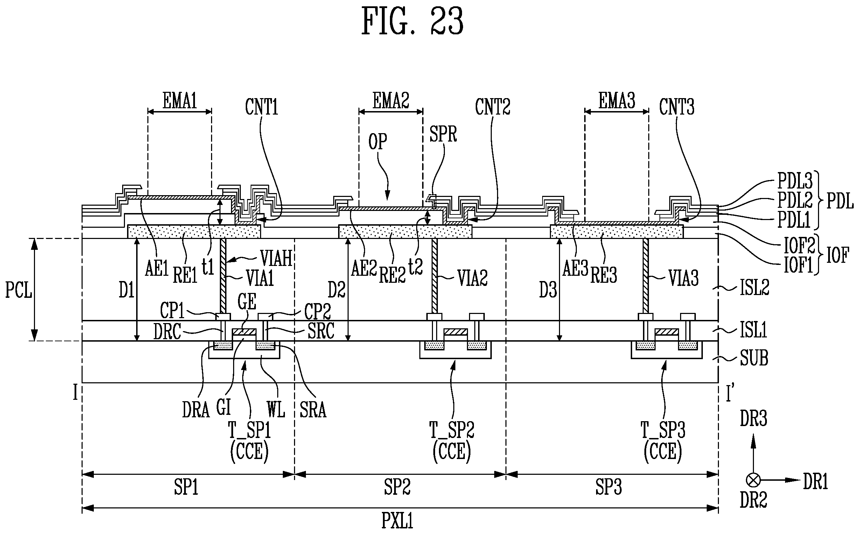

Referring to FIG. 23, a pixel definition layer PDL may be formed on the inorganic film IOF and the first to third anode electrodes AE1-AE3. In the pixel definition layer PDL, an opening OP exposing a portion of each of the first to third anode electrodes AE1-AE3 may be formed.

The pixel definition layer PDL may include first to third pixel definition films PDL1-PDL3, and a first pixel definition film PDL1 may be formed on the inorganic film IOF and the first to third anode electrodes AE1-AE3, a second pixel definition film PDL2 may be formed on the first pixel definition film PDL1, and a third pixel definition film PDL3 may be formed on the second pixel definition film PDL2. In such embodiments, the third pixel definition film PDL3 may be formed to have a wider width than the first and second pixel definition films PDL1, PDL2 so that side surfaces of the first to third pixel definition films PDL1-PDL3 adjacent to the opening OP may be provided as a separator SPR.

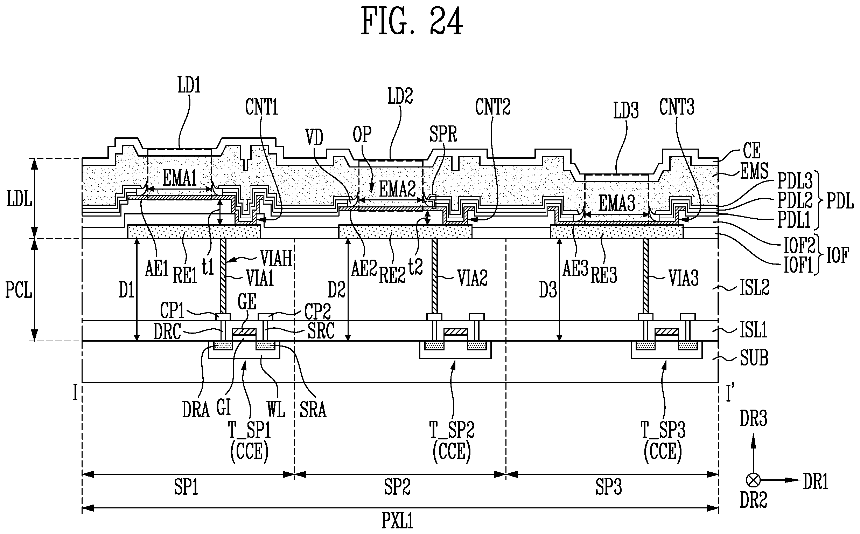

Referring to FIG. 24, a light-emitting structure EMS may be formed on the first to third anode electrodes AE1-AE3 and the pixel definition layer PDL. The light-emitting structure EMS may fill the openings OP of the pixel definition layer PDL and may be formed over all of the first to third sub-pixels SP1-SP3 (e.g., may be formed across each of, an entirety of, or substantially the entirety of the first to third sub-pixels SP1-SP3). The light-emitting structure EMS may be formed over all of the first to third sub-pixels SP1-SP3 at the same time and may be formed with substantially the same thickness across the first to third sub-pixels SP1-SP3.

The light-emitting structure EMS may be at least partially disconnected or bent in a boundary area by the separator SPR. For example, some of the plurality of layers laminated within the light-emitting structure EMS may be disconnected or bent by the voids VD. As such, due to the separator SPR, portions of the light-emitting structure EMS included in the first to third sub-pixels SP1-SP3 may be at least partially separated.

A cathode electrode CE may be formed on the light-emitting structure EMS. The cathode electrode CE may be commonly formed on the first to third sub-pixels SP1-SP3. The cathode electrode CE may be formed over all of first to third sub-pixels SP1-SP3 at the same time, and may be formed with substantially the same thickness across the first to third sub-pixels SP1-SP3.

The first anode electrode AE1, a portion of the light-emitting structure EMS overlapping the first anode electrode AE1, and a portion of the cathode electrode CE overlapping the first anode electrode AE1 may form a first light-emitting element LD1. The second anode electrode AE2, a portion of the light-emitting structure EMS overlapping the second anode electrode AE2, and a portion of the cathode electrode CE overlapping the second anode electrode AE2 may form a second light-emitting element LD2. The third anode electrode AE3, a portion of the light-emitting structure EMS overlapping the third anode electrode AE3, and a portion of the cathode electrode CE overlapping the third anode electrode AE3 may form a third light-emitting element LD3.

Because the light-emitting structure EMS and the cathode electrode CE have the same thickness over all the sub-pixels SP, the distances between each of the first to third reflective electrodes RE1-RE3 and the cathode electrode CE may be different from each other due to the inorganic film IOF.

For example, the distance between the first reflective electrode RE1 and the cathode electrode CE may be longer than the distance between the second reflective electrode RE2 and the cathode electrode CE, and the distance between the second reflective electrode RE2 and the cathode electrode CE may be longer than the distance between the third reflective electrode RE3 and the cathode electrode CE. Accordingly, the distance between each reflective electrode and the cathode electrode CE may be individually adjusted so that the first to third light-emitting elements LD1-LD3 may be formed so that each of the first to third light-emitting areas EMA1-EMA3 has an optimal or suitable resonance distance.

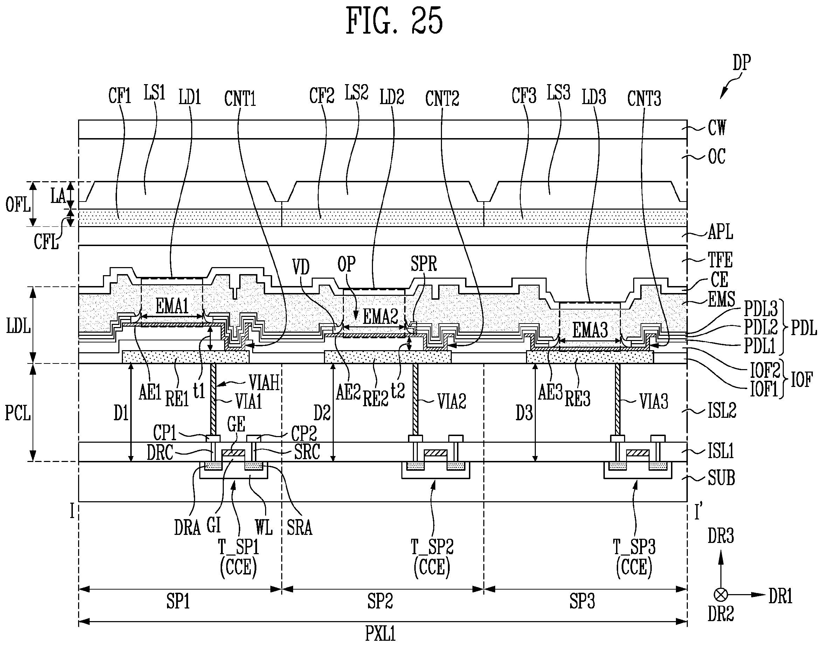

Referring to FIG. 25, an encapsulation layer TFE may be formed on the cathode electrode CE. An optical functional layer OFL may be formed on the encapsulation layer TFE. The optical functional layer OFL may be attached to the encapsulation layer TFE via an adhesive layer APL. The optical functional layer OFL may include a color filter layer CFL and a lens array LA. An overcoat layer OC may be formed on the optical functional layer OFL. A cover window CW may be formed on the overcoat layer OC. Accordingly, a display device may be formed.

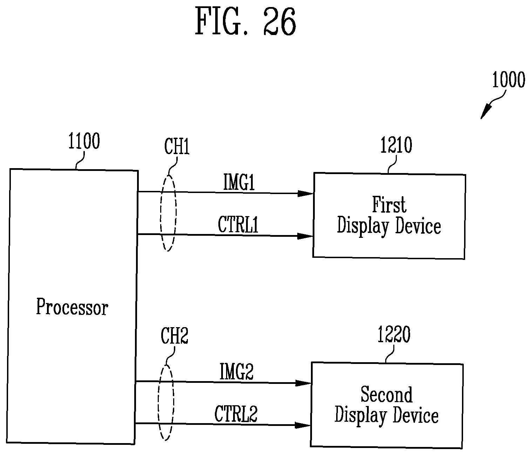

FIG. 26 is a block diagram illustrating a display system according to one or more embodiments of the present disclosure.

Referring to FIG. 26, a display system 1000 may include a processor 1100 and one or more display devices 1210, 1220.

The processor 1100 may perform one or more suitable tasks and calculations. In one or more embodiments, the processor 1100 may include an application processor, a graphic processor, a microprocessor, a central processing unit (CPU), and/or the like. The processor 1100 may be connected to other components of the display system 1000 via a bus system and may control them.

In FIG. 26, the display system 1000 is illustrated as including first and second display devices 1210, 1220. The processor 1100 may be connected to the first display device 1210 through a first channel CH1 and may be connected to the second display device 1220 through a second channel CH2.

Through the first channel CH1, the processor 1100 may be configured to transmit first image data IMG1 and a first control signal CTRL1 to the first display device 1210. The first display device 1210 may display an image based on the first image data IMG1 and the first control signal CTRL1. The first display device 1210 may be configured substantially the same or similarly to the display device 100 described with reference to FIG. 1. In such embodiments, the first image data IMG1 and the first control signal CTRL1 may be provided as the input image data IMG and the control signal CTRL of FIG. 1, respectively.

Through the second channel CH2, the processor 1100 may be to transmit the second image data IMG2 and the second control signal CTRL2 to the second display device 1220. The second display device 1220 may display an image based on the second image data IMG2 and the second control signal CTRL2. The second display device 1220 may be configured substantially the same or similarly to the display device 100 described with reference to FIG. 1. In such embodiments, the second image data IMG2 and the second control signal CTRL2 may be provided as the input image data IMG and the control signal CTRL of FIG. 1, respectively.

The display system 1000 may include a computing system providing an image display function, such as a portable computer, a mobile phone, a smart phone, a tablet personal computer, a smart watch, a watch phone, a portable multimedia player (PMP), a navigation, an ultra-mobile personal computer (UMPC), and/or the like. In one or more embodiments, the display system 1000 may include at least one of a head mounted display (HMD), a virtual reality (VR) device, a mixed reality (MR) device, and an augmented reality (AR) device.

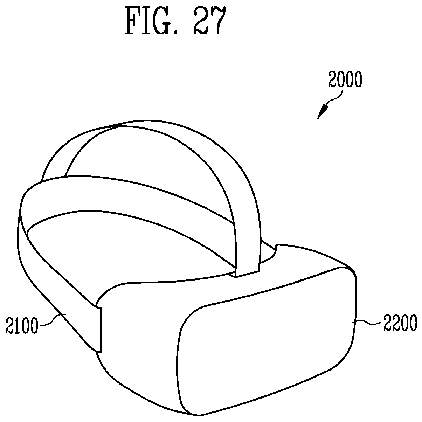

FIG. 27 is a perspective view illustrating an application of the display system of FIG. 26, according to one or more embodiments of the present disclosure.

Referring to FIG. 27, the display system 1000 of FIG. 26 may be applied to a head mounted display device 2000. The head mounted display device 2000 may be a wearable electronic device that may be worn on a user's head.

The head mounted display device 2000 may include a head mounted band 2100 and a display device storage case 2200. The head mounted band 2100 may be connected to the display device storage case 2200. The head mounted band 2100 may include a horizontal band and/or a vertical band for fixing the head mounted display device 2000 to the user's head. The horizontal band may be configured to be around (e.g., surround) the side of the user's head, and the vertical band may be configured to be around (e.g., surround) the upper part of the user's head. However, the present disclosure is not limited thereto. For example, the head mounted band 2100 may be implemented in a form of a glasses frame, a helmet, and/or the like.

The display device storage case 2200 may store the first and second display devices 1210, 1220 of FIG. 26. The display device storage case 2200 may further store the processor 1100 of FIG. 26.

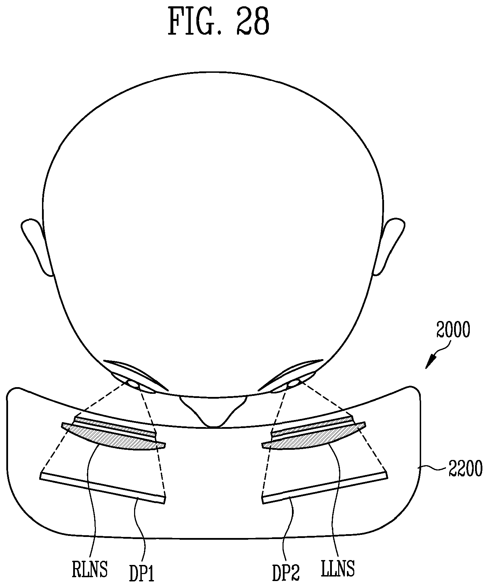

FIG. 28 is a diagram illustrating a head mounted display device of FIG. 27 worn by a user, according to one or more embodiments of the present disclosure.

Referring to FIG. 28, a first display panel DP1 of the first display device 1210 and a second display panel DP2 of the second display device 1220 are arranged within the head mounted display device 2000. The head mounted display device 2000 may further include one or more lenses LLNS, RLNS.

Within the display device storage case 2200, a right eye lens RLNS may be arranged between the first display panel DP1 and a user's right eye. Within the display device storage case 2200, the left eye lens LLNS may be arranged between the second display panel DP2 and the user's left eye.

An image output from the first display panel DP1 may be displayed to the user's right eye through the right eye lens RLNS. The right eye lens RLNS may refract light from the first display panel DP1 toward the user's right eye. The right eye lens RLNS may perform an optical function for adjusting a viewing distance between the first display panel DP1 and the user's right eye.

An image output from the second display panel DP2 may be displayed to the user's left eye through the left eye lens LLNS. The left eye lens LLNS may refract light from the second display panel DP2 toward the user's left eye. The left eye lens LLNS may perform an optical function for adjusting a viewing distance between the second display panel DP2 and the user's left eye.

In one or more embodiments, each of the right eye lens RLNS and the left eye lens LLNS may include an optical lens having a cross-section in the shape of a pancake (e.g., may be convex). In one or more embodiments, each of the right eye lens RLNS and the left eye lens LLNS may include a multi-channel lens including sub-areas having different optical characteristics. In such embodiments, each display panel outputs images corresponding to the sub-areas of the multi-channel lens, and the output images may be shown to the user by passing through the corresponding sub-area.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Further, the use of "may" when describing embodiments of the present disclosure refers to "one or more embodiments of the present disclosure."

As used herein, the term "substantially," "about," and similar terms are used as terms of approximation and not as terms of degree, and are intended to account for the inherent deviations in measured or calculated values that would be recognized by those of ordinary skill in the art. "Substantially" as used herein, is inclusive of the stated value and means within an acceptable range of deviation for the particular value as determined by one of ordinary skill in the art, considering the measurement in question and the error associated with measurement of the particular quantity i.e., the limitations of the measurement system. For example, "substantially" may mean within one or more standard deviations, or within ± 30%, 20%, 10%, 5% of the stated value.

Also, any numerical range disclosed and/or recited herein is intended to include all sub-ranges of the same numerical precision subsumed within the recited range. For example, a range of "1.0 to 10.0" is intended to include all subranges between and including the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

The display device, electronic apparatus, device for manufacturing the display device, or any other relevant devices or components according to embodiments of the present disclosure described herein may be implemented utilizing any suitable hardware, firmware e.g., an application-specific integrated circuit, software, or a combination of software, firmware, and hardware. For example, the various components of the device may be formed on one integrated circuit IC chip or on separate IC chips. Further, the various components of the device may be implemented on a flexible printed circuit film, a tape carrier package TCP, a printed circuit board PCB, or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory RAM. The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. It is to be understood that the foregoing is an illustration of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display device comprising:
a substrate having first to third light-emitting areas;
circuit elements on the substrate;
an insulating layer on the circuit elements and defining via holes, each of the via holes overlapping one of the circuit elements;
reflective electrodes on the insulating layer and each of the reflective electrodes overlapping one of the first to third light-emitting areas;
anode electrodes, each of the anode electrodes on a corresponding one of the reflective electrodes and overlapping the corresponding one of the reflective electrodes;
a light-emitting structure on the anode electrodes;
a cathode electrode on the light-emitting structure; and
via electrodes in the via holes of the insulating layer between the circuit elements and the reflective electrodes to connect the circuit elements and the reflective electrodes to each other,
wherein a distance between a reflective electrode of the reflective electrodes and its corresponding anode electrode of the anode electrodes that overlaps the reflective electrode in one of the first to third light-emitting areas is different from a distance between another reflective electrode of the reflective electrodes and its corresponding anode electrode of the anode electrodes that overlaps the other reflective electrode in a different one of the first to third light-emitting areas.

2. The display device as claimed in claim 1, wherein the insulating layer has a planar upper surface except for at the via holes, and
a distance from each of the reflective electrodes to the substrate is the same in the first to third light-emitting areas.

3. The display device as claimed in claim 2, wherein at least one of the anode electrodes has a different distance to the substrate from the rest of the anode electrodes.

4. The display device as claimed in claim 3, further comprising an inorganic film between the reflective electrodes and the anode electrodes.

5. The display device as claimed in claim 4, wherein the inorganic film has a different thickness in at least one of the first to third light-emitting areas relative to the remaining areas of the first to third light-emitting areas.

6. The display device as claimed in claim 5, wherein the inorganic film has a smaller thickness in one light-emitting area of the first to third light-emitting areas that emits light of a shorter wavelength than other light-emitting areas of the first to third light-emitting areas.

7. The display device as claimed in claim 5 or claim 6, wherein the inorganic film overlaps the first to third light-emitting areas except for one light-emitting area from among the first to third light-emitting areas; or
wherein the inorganic film overlaps each of the first to third light-emitting areas and has the same thickness in only two light-emitting areas from among the first to third light-emitting areas.

8. The display device as claimed in any of claims 4 to 7, wherein the inorganic film further comprises contact holes, each of the contact holes overlapping one of the anode electrodes, and
each of the anode electrodes is connected to one of the reflective electrodes by directly contacting the one of the reflective electrodes through one of the contact holes.

9. The display device as claimed in any of claims 4 to 8, wherein the inorganic film comprises at least one of silicon oxide (SiOₓ), silicon nitride (SiNₓ), and/or silicon oxynitride (SiON).

10. The display device as claimed in any preceding claim, wherein
(i) each of the reflective electrodes comprises at least one of titanium (Ti), titanium nitride (TiN), tantalum nitride (TaN), aluminum (Al), and/or silver (Ag); and/or
(ii) each of the anode electrodes comprises at least one of indium tin oxide (ITO), indium zinc oxide (IZO), and/or titanium nitride (TiN); and/or
(iii) each of the via electrodes comprises at least one of tungsten (W) and/or copper (Cu).

11. A method for manufacturing a display device, the method comprising:
forming circuit elements on a substrate;
forming an insulating layer on the circuit elements, the insulating layer defining via holes, each of the via holes overlapping a corresponding one of the circuit elements;
forming via electrodes on the circuit elements, each of the via electrodes connected to a corresponding one of the circuit elements through the via holes of the insulating layer;
forming reflective electrodes on the insulating layer, each of the reflective electrodes connected to a corresponding one of the via electrodes and each of the reflective electrodes overlapping a corresponding one of first to third light-emitting areas;
forming anode electrodes on the reflective electrodes, each of the anode electrodes overlapping a corresponding one of the reflective electrodes
forming a light-emitting structure on the anode electrodes; and
forming a cathode electrode on the light-emitting structure,
wherein a distance between a reflective electrode of the reflective electrodes and its corresponding anode electrode of the anode electrodes that overlaps the reflective electrode in one of the first to third light-emitting areas is different from a distance between another reflective electrode of the reflective electrodes and its corresponding anode electrode of the anode electrodes that overlaps the other reflective electrode in a different one of the first to third light-emitting areas.

12. The method as claimed in claim 11, further comprising, after the forming of the via electrodes, planarizing the insulating layer and the via electrodes through a polishing process.

13. The method as claimed in claim 12, wherein each of the reflective electrodes is in contact with the insulating layer, and a distance from each of the reflective electrodes to the substrate is the same in the first to third light-emitting areas.

14. The method as claimed in claim 13, further comprising,
after the forming of the reflective electrodes, and before the forming of the anode electrodes,
forming an inorganic film on the reflective electrodes;
optionally wherein the inorganic film comprises a first inorganic film and a second inorganic film on the first inorganic film;
further optionally wherein the forming of the inorganic film comprises:
forming a first preliminary inorganic film on the insulating layer and the reflective electrodes;
forming the first inorganic film by removing first portions of the first preliminary inorganic film overlapping two light-emitting areas from among the first to third light-emitting areas;
forming a second preliminary inorganic film on the first inorganic film; and
forming the second inorganic film by removing a second portion of the second preliminary inorganic film overlapping one light-emitting area from among the first to third light-emitting areas.

15. An electronic device comprising:
a display device comprising:
a substrate having first to third light-emitting areas;
circuit elements on the substrate;
an insulating layer on the circuit elements and defining via holes, each of the via holes overlapping one of the circuit elements;
reflective electrodes on the insulating layer and each of the reflective electrodes overlapping one of the first to third light-emitting areas;
anode electrodes, each of the anode electrodes on a corresponding one of the reflective electrodes and overlapping the corresponding one of the reflective electrodes;
a light-emitting structure on the anode electrodes;
a cathode electrode on the light-emitting structure; and
via electrodes in the via holes of the insulating layer between the circuit elements and the reflective electrodes to connect the circuit elements and the reflective electrodes to each other,
wherein a distance between a reflective electrode of the reflective electrodes and a corresponding anode electrode of the anode electrodes that overlaps the reflective electrode in one of the first to third light-emitting areas is different from a distance between another reflective electrode of the reflective electrodes and its corresponding anode electrode of the anode electrodes that overlaps the other reflective electrode in a different one of the first to third light-emitting areas.
